(19) 

**Europäisches Patentamt**
**European Patent Office**
**Office européen des brevets**

(11) **EP 2 180 520 A1**

(12) **EUROPEAN PATENT APPLICATION**
published in accordance with Art. 153(4) EPC

(43) Date of publication:
**28.04.2010 Bulletin 2010/17**

(51) Int Cl.:
***H01L 31/04*** *(2006.01)*

(21) Application number: **08827372.7**

(22) Date of filing: **25.07.2008**

(86) International application number:
**PCT/RU2008/000490**

(87) International publication number:
**WO 2009/022945 (19.02.2009 Gazette 2009/08)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **01.08.2007 RU 2007129517**

(71) Applicant: **Tsoi, Bronya**
**Moscow, 117342 (RU)**

(72) Inventor: **BUDISHEVSKY, Jury Dmitrievich**
**Bryansk 241047 (RU)**

(74) Representative: **Lemcke, Brommer & Partner**
**Patentanwälte**
**Bismarckstrasse 16**
**76133 Karlsruhe (DE)**

(54) **ELECTROMAGNETIC EMISSION CONVERTER**

(57) The invention relates to electromagnetic radiation converters. In a first embodiment, the inventive converter comprises at least one collecting region of a first conductivity type, at least one collecting region of a second conductivity type and first and second current-collecting conducting electrodes. On a first, second conductivity type substrate side sensitive to the incident electromagnetic radiation, N > 1 first conductivity type regions are provided, each of which spaced apart at a distance of F < 2f from other regions of the same conductivity type, where f is a quantity commensurable with or equal to the diffusion length of non-equilibrium minority charge carriers. In a second embodiment, the inventive converter comprises at least one collecting region of a first conductivity type, at least one collecting region of a second conductivity type and first and second current-collecting conducting electrodes. The first electrode is connected to said first conductivity type region arranged on a first, second conductivity type substrate side sensitive to the incident electromagnetic radiation, said first electrode comprising T > 1 portions and the distance between each two of said portions being less than 2f, where f is a value commensurable with or equal to the diffusion length of non-equilibrium minority charge carriers, said portions of the first electrode being combined into a current node in the internal circuit of the converter by means of at least one current-conducting bus. As a result, an increase in the energy conversion efficiency (increased performance) is ensured over the prior art solutions.

EP 2 180 520 A1

**Description**

TECHNICAL FIELD

The invention relates to electromagnetic radiation (EMR) converters, in particular to double-sided converters wherein a first side and a second side of the semiconductor substrate comprise radiation sensors directly converting incident radiation into electromotive force (EMF) both within optically visible and invisible frequency band (IR and lower, UV and upper), and is applicable for producing wideband high-performance photoelectric converters (PEC)

DESCRIPTION OF THE PRIOR ART

The currently known PEC or solar cells (SC) or photovoltaic cells (PVC) are able to receive and convert a relatively small portion of the electromagnetic wave (EMW) spectrum within the visible frequency band of the solar radiation ($10^{14}$-$10^{15}$ Hz) including a limited portion of the IR frequency band (slightly below $10^{14}$ Hz) and a small portion of the UV frequency band (slightly above $10^{15}$ Hz), which reach the earth surface only during the daylight time under satisfactory meteorological conditions. As this takes place, a considerable portion of the external EMR reaching the earth surface is left out of the conversion range.

Most of the prior art PEC designs are based on the conventional semiconductor technology according to which a p-n-junction is formed in the basic semiconducting material (of p- or n-conductivity type) by means of impurity doping [Alferov Zh.J., Andreev V.M., Rumyantsev V.D. /Development Trends and Prospects of Solar Power Engineering. // Semiconductor Physics and Technology, 2004, Vol. 38, Issue 8, PP 937-948.;

Meitin M. / Photovoltaics: Materials. Technologies, Prospects // Electronics: Science, Technology, Business, 2000, No.6, PP 40-46:

Konstantinov P.B., Kontsevoy Yu.A., Maksimov Yu.A., Silicon Solar Cells, Moscow, MIREA Publishers, 2005, 70 PP;

Reivi K., Defects and Impurities in Semiconducting Silicon, Moscow, Mir Publishers, 1984, 470 PP;

Zaveryuikhin B.N., Zaveryuikhina N.N.. Tursunkulov O.M. /Changes in the Reflection Factor of Radiation from the Semiconductor Surface within the Spectral Range of $\lambda = 0.2$-20 $\mu$m under the Influence of Ultrasonic Waves //Letters to the Journal of Applied Physics, 2002, Vol. 28, Issue 18, PP 1-12;

Green M.A et al., 25% Efficient Low-Resistivity Si Concentrator Solar Cells, IEE Electron Device Letters, 1986, PP. 583-585;

JP 3206350 B2, 26.01.1995;

RU 2139601 CI, 04.12.1998].

In all converter designs comprising a conventional diode configuration, a p-n-junction is usually created in the form of either a continuous acceptor region or one donor region. Two separate electrodes - an anode (positive) and a cathode (negative) are arranged adjacent to p- and n-regions.

In order that such diode may operate as a photovoltaic cell (PVC) or a PEC, an external inciting factor is required, in this case the EMR. Non-equilibrium minority charge carriers (MCC)-electron-hole pairs (EHP) which are caused to separate by diffusion are formed within the semiconductor bulk as the EMR is absorbed.

The "minority" carriers (holes in the n-semiconductor and electrons in the p-semiconductor given a charge concentration gradient) generated in the vicinity of the p-n-junction diffuse towards the p-n-junction, are taken up by the p-n-junction field and released into the opposite conductivity-type semiconductor to become majority charge carriers therein: electrons will be localized in the n-type semiconductor while holes - in the p-type semiconductor. As a result, the p-type semiconductor is given an excessive positive charge and the n-type semiconductor a negative one. Between the SC p-n regions, a contact voltage drop occurs, which forms a photo-EMF or an open-circuit voltage. The photo-EMF polarity corresponds to the p-n-junction direct bias which lowers the height of a potential barrier and facilitates injection of the holes from the p-region into the n-region and of the electrons from the n-region into the p-region. By the action of these two opposite mechanisms - accumulation of the current carriers under the influence of the EMR quantum and and their outflow due to lowering the potential barrier height - different photo-EMF values are defined depending on different EMR intensities. The photo-EMF value increases in proportion to the value of the intensity logarithm within a wide range of the photometric intensity.

As this takes place, MCC are trapped by the p-n-junction field and pass into the opposite-conductivity region to become majority carriers and accumulate at the current-collecting electrodes. The resulting photocurrent is of diffusive character and its value is considered to be proportionate to the EMR absorption region.

MCC and electron-hole pair (EHP) creation and separation processes in the converters compete with the recombination processes of the same at the surface of and within the PEC bulk. Recombination at the surface of the converter substrate is several times in excess of this value within the bulk. The competition of these two processes - EHP creation and recombination thereof - determines the value of the photocurrent being generated. Therefore, in order to reduce the surface recombination, all prior art converters without exception are provided with a front face comprising a continuous (integral, with no discontinuity portions) doped or diffusion similar region or part. [Goodrich J., Chaple-Sokol., Allendore G., Frank R. The etched multiple vertical junction silicon photovoltaic cell//Solar Cells, 1982. Vol. 6, N 1, P, 87-101;

Aberie A.G., Altermatt P.P., Heizer G, Robinson S.J. Limiting loss mechanisms in 23% efficient silicon solar cells // J.Appl. Phys., 1995, Vol. 77, N 7, P/ 3491/;

DE 10127382 Al. 06.06.2001;

Untila G.G., Kost T.N., Zaks M.B. et al. /New Type of High-performance Two-Sided Silicon Solar Cella with External Buses and Wire Grid // Semiconductor Physics and Technology, 2005, Vol. 39, Issue 11, PP. 1393-1398;

US 6,998,288 B1,14.02.2006].

In order that free $e^-$ $h^+$ EHP may form, the following condition should be met: the incident wave energy at least in case of its own absorption E = hv (where h is Planck's constant and v is an incident wave frequency) should be equal to or exceed the energy of the semiconductor forbidden band $\Delta E$ width: hv $\geq \Delta E$.

The forbidden band width (FBW) for various semiconductor materials amounts to: gallium arsenide (GaAs) - $\Delta E$ = 1.43 eV; cuprum and indium diselenide (Cu-InSeOB$_2$) - $\Delta E$ = 1 eV; cadmium telluride (CdTe) - $\Delta E$ = 1.44 eV; silicon - $\Delta E$ = 1.1 eV; germanium (Ge) - $\Delta E$ = 0.72 eV.

Semiconductors with the FBW of 1.4 eV are able to convert electromagnetic waves beginning with the FM band radio waves (- $4 \cdot 10^7$ Hz) and above. Therefore, the electromagnetic wave energy at $4 \cdot 10^7$ Hz (belonging to the FM band) amounts to: hv = $6.626 \cdot 10^{-27}$ J · sec · $4 \cdot 10^7$ Hz = $2.65 \cdot 10^{-19}$ J= 1.65 eV.

A considerable part ofthe EMR range (below and above the visible frequency band) is not used. However, these waves, for example, millimetric waves in sufficient quantities reach the earth surface from the outer space, in addition at any time and any meteorological conditions. The hyper-high frequency EMR, beginning with the UV radiation is known to abound across a vast region of our planet. Moreover, earth stations which round-the-clock dissipate energy into the universal space provide a plenty of the EMR.

The EMR short-wave region is not available for conversion due to the fact that most of the high-frequency ($10^{15}$ Hz and above) incident waves arc reflected from the PEC surface (the higher the doping level is, the higher the reflection index), with the MCC concentration and diffusion length thereof being negligibly small so that the MCC formed by absorbing high-energy quanta recombinate within the same layer. However, in cases of interaction with the long-wave region EMR (below $10^{14}$ Hz) to which the semiconductor is transparent, the MCC are formed with equal probability throughout the absorption bulk, and the MCC concentration gradient is in fact equal to zero, therefore, the diffusive current component is also equal to zero. This physical phenomenon comprises a principle limitation of all current converters whose operation is essentially based on the diffusion effects of EHP separation.

The main processes limiting the semiconductor SC efficiency include the EMR reflection from the converter surface; transmission of a part of the EMR through the converter without being absorbed therein; scattering of the excess energy of the EMR photons due to lattice-thermal vibration; recombination of the generated EHP at the surfaces of and within the converter bulk; converter internal resistance; etc., which are discussed below. [Alferov Zh.I., Andreev V.M., Rumyantsev V.D. /Development Trends and Prospects of Solar Power Engineering. //Semiconductor Physics and Technology, 2004, Vol. 38, Issue 8, PP 937-948; Meitin M. / Photovoltaics: Materials, Technologies, Prospects // Electronics: Science, Technology, Business, 2000, No. 6, PP 40-46; Konstantinov P.B., Kontsevoy Yu.A., Maksimov Yu.A., Silicon Solar Cells, Moscow, MIREA Publishers, 2005, 70 PP]

PEC is usually formed on a plate of semiconductor material, for example, silicon using the above method. In doing so, a continuous lower contact of the converter to the underside is usually provided and the upper contact to the exposed side is provided in the form of a comb structure (strips of 100-250 $\mu$m in width connected by a relatively wider bus), with the distance between the strips being of 2000-3000 $\mu$m at 5-10% shading of the converter exposed side. In order to create the repulsive field and to improve the ohmic contact, the plate surface is further subdoped on the underside.

Standard continuous converters are arranged on the p- or n-conductivity type semiconductor. Due to the prevailing diffusive current component and differences in the mobility of electrons $e^-$ and that of holes $h^+$, preference is given to the substrates of p-type silicon wherein the mobility of the minority charge carriers (MCC), i.e. electrons is three times higher than that of the holes.

Further discussions will be true for any p- or n-conductivity type semiconductor (Ge, Si. GaAs, etc.), however, p-conductivity type silicon is usually preferred due to the differences in the mobility of $h^+$ and $e^-$.

For simplicity of the discussion of the inventive converter embodiments, n-conductivity type is conventionally referred to as a first conductivity type, and p-conductivity type as a second conductivity type (accordingly, a first conductivity type region and a second conductivity type region). At the same time, both substrate sides of the converters according to the invention may comprise EMR sensors. Therefore, the substrate side with the first $n^+$ conductivity type doped regions provided thereon is conventionally referred to as a first side, and the opposite side of the second $p^+$ conductivity type basic layer - as a second side. Accordingly, the electrodes adjacent to the first conductivity type collecting regions are referred to as first electrodes and the electrodes adjacent to the second conductivity type collecting regions - as second electrodes.

The lifetime of MCC $n^+$ holes in the $n^-$ layer is negligibly small, highly dependent on the diffusion condition and decreases due to dislocations being formed and discharge of excessive phosphorous in the form of SiP-precipitates. The $n^+$ layer in the vicinity of the surface with a high content of SiP-precipitates is usually referred to as a dead layer since this region is electrically inactive. At the same time the $n^+$ layer serves to cut off the high-frequency component of the electromagnetic radiation spectrum [Reivi K., Defects and Impurities in Semiconducting Silicon, Moscow, Mir Publishers, 1984, 470 PP].

A high content of the free majority charge carriers, i.e. electrons in the $n^+$ layer substantially alters the reflectivity of silicon: the higher the doping level is, the higher the reflection index [Zaveryuikhin B.N., Zaveryuikhina N.N., Tursunkulov O.M. / Changes in the Reflection Factor of Radiation from the Semiconductor Surface within the Spectral Range of $\lambda$ = 0.2-20 $\mu$m under the Influence of Ultrasonic Waves //Letters to the Journal of Applied Physics, 2002, Vol. 28, Issue 18, PP 1-12;]. That is, a high content of electrons in the $n^-$ layer is a reason for cutting off a considerable part of the EMR short-wave spectrum. Therefore, in practice this layer is made as thin as possible to improve the PEC efficiency.

Various techniques are known in the patent literature for eliminating these factors limiting the efficiency. When designing and manufacturing the SC, special emphasis is placed on optimizing the collecting $n^+$ layer.

A method is known for optimizing the $n^+$ layer parameters [Konstantinov P.B., Kontsevoy Yu.A., Maksimov Yu.A. Silicon Solar Cells, Moscow, MIRE Publishers, 2005, 70 PPI. This layer is made thin and with a low doping level as it is rather difficult to avoid SiP precipitates by diffusion and to ensure an optimum dope level. Incorporation of phosphorous by means of ion-implantation doping makes it possible to overcome said obstacle, however, the disturbances occurring in silicon as this happens notably decrease the lifetime of the $e^-$ MCC in the p-layer whereby the long-wave red spectrum region is limited.

However, the occurrence depth and the doping level of the n-layer cannot be reduced to ultrasmall values since otherwise the so called "sheet" resistance (spreading resistance) and hence the converter series resistance would increase.

A method is known for increasing the contact voltage drop $\varphi_e$ by means of forming a $p^+$ layer under the n-layer [JP 3206350 B2, 26.01.1995] wherein a SC is disclosed having the $p^+$ layer formed under the n-layer for increasing the voltage drop, i.e. the open-circuit voltage.

In fact, this drop will be less due to generation-recombination processes at the boundary of the highly-doped regions.

A method is known for reducing recombination [RU 2139601 Cl, 04.12.1998] by means of increasing the MCC lifetime in thermal processes, wherein boron and phosphorous are caused to simultaneously diffuse from the applied sources (gettering); front surface is textured; a shallow $n^+$ collecting region is created; the efficiency of 16.6% is achieved.

A method is known for improving the efficiency, wherein the converter series resistance is decreased by creating an embedded $n^{++}$ layer under the current-collecting bus whereby the efficiency is raised to 18.5%.

A technique is known for reducing recombination losses at the surface by implementing a "pinpoint contact" type metallization pattern whereby the efficiency of 23% is achieved.

A method is known for improving the efficiency [11] by reducing optical losses using photolithographic surface texturing, wherein zone silicon with a high MCC lifetime and a high-quality thermal oxide is used to achieve the efficiency of 23-25%.

A technique is known for reducing optical losses by applying $Si_3N_4$, $TiO_2$ antireflection coatings or other films with a refraction index of more than 1.8 onto the front surface or by using the transparent current-conducting TCO or ITO layer (comprising at the same time the antireflection layer) and using the wire contact system under the laminated layer whereby the efficiency of 17.7% is achieved.

A method is known for reducing optical losses using membrane converters having the continuous $n^+$ region arranged on the back surface. However, these converters have a low sensitivity within the "red" spectrum region, are difficult to make and have poor mechanical stability.

A converter with vertical grooves is known, said converter has a continuous $n^+$ region, requires a high MCC lifetime to ensure good performance within the "blue" region since the non-equilibrium electrons have to travel over a long distance to teach the $n^+$ layer; whose main drawbacks comprise complicated manufacturing technique and high cost [Goodrich J., Chaple-Sokol., Allendore G., Frank R., The etched multiple vertical junction silicon photovoltaic cell //Solar Cells. 1982. Vol. 6, N 1. P. 87-101]; the achieved efficiency amounts to 18.5%.

A converter is known [US 6,998,288 B1, 14.02.2006] provided with a front reflective layer repulsive layer and shadow comb system, with the efficiency of said converter being of 20%. In this case, no doped front layer in involved in the current collection by the MCC, i.e. in the element internal resistance, therefore it may be formed thin and moderately doped. Such systems are easy to implement technically but are associated with a number of conditions: expensive basic material, zone melting silicon is required which should meet a number of strict requirements (high lifetime and high homogeneity). That is, all techniques should be applied in order to preserve the MCC lifetime otherwise the efficiency within the short-wave spectrum region would be lost since given small diffusion lengths, the MCC which have formed would recombine within the bulk before reaching the current-collecting electrodes so that the basic semiconductor thickness will have to be reduced which in turn will result in a loss within the long-wave spectrum region.

It should be emphasized that all converter designs have two elements in common: 1) a large-region continuous collecting n⁺ layer, 2) current-conducting buses being arranged on this continuous layer in the form of a comb with widely-spaced teeth or widely-spaced strips. The bus strips or comb teeth are spaced apart at intervals of 2-3 mm and more with the width of the bus strips or comb teeth being of 100 $\mu$m and more.

Moreover, the highest energy and efficiency UV and higher spectrum region and the low-frequency (LF) IR and lower region are left out of conversion in all current converters.

Meanwhile, conversion of both the UF and higher solar spectrum region, in particular as applied to hard UV and roentgen radiation, and the IR and lower spectrum region constitutes a main solution to the power scarcity of spacecrafts; and conversion of the UF region (with the quantum energy of 3-5.5 eV freely reaching the earth surface) and the low-frequency (LF) of the long-wave EMR range, in particular lower than the visible IR solar spectrum region might provide a solution to the world energy demand. In general, broadening of the convertible frequency spectrum would lead to a cardinal cost reduction of the "alternative" electric energy.

SUMMARY OF THE INVENTION

In view of the above mentioned drawbacks of the prior art solutions, it is an object of the invention to provide a new generation of devices which are able to convert, apart from the conventional (visible) EMR frequency band, a wider, invisible frequency band and are not only technically different but are also more cost effective, less expensive and adaptable to the current production level.

Said object is achieved by providing an electromagnetic radiation converter comprising at least one collecting region of a first conductivity type and at least one collecting region of a second conductivity type, as well as a first and a second current-collecting conducting electrodes connected to said regions, wherein according to a first embodiment on a first, second conductivity type substrate side sensitive to the incident electromagnetic radiation, N > 1 first conductivity type regions are arranged, each region being spaced at a distance of F < 2f from other regions of the same conductivity type, where f is a value commensurable with or equal to the diffusion length of non-equilibrium minority charge carriers.

Preferably, said first current-collecting electrode is electrically connected to each of said N regions of the first conductivity type.

In a preferred case, said first current-collecting electrode has N portions each of which is adjacent to one of said N first conductivity regions, with said N portions of the first electrode being combined by means of at least one current bus.

At the same time, said portions of the first electrode are preferably arranged as strips, with the width of each strip portion of the first electrode preferably not exceeding 50 $\mu$m. Said strip portions are also preferably spaced apart at intervals of less than 2f.

In a particular case, discrete quantum trapping depressions may be provided on the first substrate side between said portions of the first electrode, having a pyramidal or truncated pyramidal form in section and arranged top end down on the substrate at a distance from each other of less than 2f.

Preferably, said quantum trapping depressions are formed in plan view as cannelures on the converter first side.

Preferably, a dielectric layer transparent to the electromagnetic radiation is arranged on the first substrate side, with recesses (apertures) being provided in said layer at least within the electric contact regions of the first electrode with the first conductivity type regions.

Preferably, second conductivity type deflecting regions are provided under the dielectric layer at the bottom of each of said cannelures, with said second conductivity type deflecting regions being possibly arranged discretely or as strips in various particular cases.

Also preferably, the second current-collecting electrode is provided on the second substrate side on top of the dielectric layer transparent to the electromagnetic radiation and having recesses (apertures) at least within the electric contact regions of the second electrode with at least one second conductivity type region on the second substrate side.

In another preferred case, the second electrode has M > 1 portions, each electrically connected to at least one second conductivity type region on the second substrate side, with said portions being combined by means of at least one current-conducting bus.

At the same time, said M portions of the second electrode may be arranged as strips, with the distance between each two strips being less than 2f.

Furthermore, discrete quantum trapping depressions may be formed on the second converter side between said portions of the second electrode, having a pyramidal or truncated pyramidal form in section, arranged on the substrate top end inward the interior of the substrate, with their base on the second side thereof, at a distance from each other of less than 2f.

Also, in a particular case, the converter may comprise at least two second conductivity type doped regions on the second side thereof, with at least one of M portions of the second electrode being electrically connected to each of said regions. In elaboration of this case, the number of said second conductivity type doped regions on the second substrate side preferably amounts to M, with one portion of the second electrode being connected to each of said regions.

Moreover, second conductivity type deflecting regions may be provided on the second side at the bottom of each of said depressions so that each of N first conductivity type regions is provided with at least one such deflecting region opposite thereto on the second side across the substrate thickness.

In a particular case, a field-effect control electrode is provided above the dielectric layer on the first side of the semiconductor substrate.

Preferably, the semiconductor substrate thickness does not exceed f, where f is a quantity commensurable with or equal to the diffusion length of non-equilibrium minority charge carriers.

The above object is also achieved by providing an electromagnetic radiation converter comprising one collecting region of a first conductivity type and at least one collecting region of a second conductivity type, as well as a first and a second current-collecting conducting electrodes connected to said regions, wherein according to a second embodiment said first electrode is connected to said first conductivity type region arranged on a first, second conductivity type substrate side sensitive to the incident electromagnetic radiation, with said first electrode comprising $T > 1$ portions, the distance between each two of said portions being less than 2f and said portions of the first electrode being combined by means at of least one current-conducting bus.

At the same time, a dielectric layer transparent to the electromagnetic radiation is preferably arranged on the first substrate side, said layer having recesses (apertures) provided at least within the electric contact regions of the first electrode portions with said first conductivity type collecting region.

In a particular case, multistage discrete voltage multipliers are provided on the converter first side integral therewith.

In another particular case, a three-stage voltage multiplier is provided on at least one of the converter sides integral therewith, with its first stage comprising a Schottky diode structure converting the short-wave region, the second stage converting the middle-wave region and the third stage converting the long-wave EMR region, all three stages being combined into a current node in the internal circuit of the converter.

In another particular case, the current-conducting elements and electrodes comprise a diffraction grating, lattice or Fresnel lenses.

The techniques used in the invention are based on the effects enhancing physical characteristics of the semiconductor substrates, discovered and revealed by the inventors and on the novel constructive solutions for implementing the same as well as known and approved prior art techniques used therein.

High power conversion efficiency is ensured in these converters by controlling the generation-recombination processes of the non-equilibrium charge carriers as well as by using phenomena related to the discrete structure of matter: transverse and longitudinal MCC concentration gradient effect, bunch or current node effect, scale effects of a change in semiconductor physical characteristics, etc.

The cost effectiveness is achieved in such converters by substantially improving their efficiency.

In all particular embodiments of the invention, the following principally novel solutions distinguished from the prior art are used: current collection by non-equilibrium MCC with negligibly short lifetimes is performed making it possible to expand the EMR range to be converted from the visible region to the invisible short-wave UF region and higher as well as to the long-wave IK region and lower; shaded SC surfaces are used for creating high transverse and longitudinal MCC concentration gradients; non-equilibrium MCC generation and recombination is controlled by means of current-collecting regions and current-collecting buses; MCC collection, generation and recombination processes are controlled by means of deflecting elements (field-effect regions); MCC collection, generation and recombination is controlled by means of field-effect electrodes just as it is done in MOS capacitors or MOS transistors; ultralow SC internal resistances are created, multilayer multijunction cells are created by means of a series type connection of the elementary cell diodes to enable a substantial power and external load increase of the SC.

The EMR short-wave spectrum region, in particular UV radiation is of considerable interest despite its small share in the solar spectrum (about 5%) due to a high quantum energy value (and accordingly quantum yield). While the quantum energy of the visible light portion amounts to 3.3 eV, the UV region energy amounts to 3.3-120 eV, with the quanta whose energy is of 3,3-5,5 eV (to which the earth's ozone layer is of no hindrance) freely reaching the earth surface. Therefore, the short-wave portion, in particular for such semiconductor materials as silicon for which one of the absorption peaks resides in the short-wave region are of considerable interest not only for space-based but also for terrestrial SC structures.

However, as noted above, no conversion of the incident high frequency EMR ($10^{15}$ Hz and higher) is available in the prior art due to its high reflection and a short lifetime of the generated MCC due to the $n^+$ layer with a high content of electrons which reflect the incident photons. At the same time, high-frequency photons are absorbed to a small extent and only within a thin surface layer of about 3-5 $\mu$m. The in-situ recombination of the generated MCC takes place within a thin surface layer. Therefore, in order to collect and pick up currents the field of p-n-junctions in the SC has to be enhanced, which may be done by introducing additional integrated electrical field sources or the collecting elements (regions, portions, etc.) have to be placed along with the current pickup (or current-collecting) buses adjacent thereto at short intervals corresponding to the MCC diffusion lengths.

No SC with control fields or sources of additional internal fields are described in the literature, and a reduction in distances between collecting elements, for example, buses is considered to result in an increased shading level of the absorbing surface and thereby in a reduced efficiency of the converter surface. According to the prior art, shading from the current pickup and current collecting buses amounts to 5-10% of the PEC total sensitive surface area and up to 3-4% from the continuous n-layer. The inventors [US 6,998,288 B1 14.02.2006] have completely evaded the shading issue by moving the contact system onto the non-exposed back side. SC structures with record low losses of the absorbing surface of just 3.2% are known from the patent literature. However, it turned out that, as it will be shown by way of examples, an increase in shading to 20% and more does not affect the SC efficiency.

The long-wave low-cnergy portion of the EMR spectrum (below $10^{14}$ Hz), in particular the IR radiation (whose share in the solar spectrum amounts to 43.5%) is of no less interest due to its transparency to semiconductor materials. This interest matters for the world solar power engineering because a considerable portion of the TR spectrum, in particular EMR of up to 4 $\mu$m freely reaches the earth surface without losses. Moreover, the millimeter-wave EMR which also freely reaches the earth is of practical interest, too. However, current PEC do not convert this spectrum portion into the EMF. Tn theory, the traditionally used semiconductors whose forbidden band is from 1.1 (silicon) to 1,43 eV (gallium arsenide) in width can convert not only the IR portion of the EMR, but also millimetric and even shorter waves since their quantum energy is of not less than 1.6 eV which is enough for generation of free electron-hole e$^-$ h$^+$ pairs in the silicon type semiconductors. During absorption of the long waves, non-equilibrium MCC form with equal probability throughout the entire absorption bulk when in the state of drift (similar to the Brownian motion), with practically no MCC concentration gradient being present so that they cannot separate by means of drift and diffusion to reach the collecting region and current collector at a too long distance from the MCC generation site. Hence, a simple solution suggests itself from here: rather than applying a high bias voltage to the converter via an additional field-effect electrode, to provide collecting regions locally at the MCC generation and destruction sites, which has been precisely done in the present invention.

Thus, MCC destruction under exposure to the incident EMR is explained by the negligibly short lifetimes and accordingly short lengths of their diffusion ranges. Therefore, in the SC according to the invention, the dimensions of the collecting regions and distances between the collecting regions with the current-collecting electrode portions adjacent thereto are provided to be negligibly small and commensurable with the values of the MC diffusion length. Accordingly, electrode portions are of a sufficiently small width - far less than 50 $\mu$m preferably provided. At the same time, regardless of the EMR frequency band to be converted, indefinitely small distances between the collecting regions, current-collecting and current-pickup buses are provided.

The collecting regions comprise first or second conductivity type low-doped regions of the semiconductor substrate.

Preferred constructive solutions comprise small-sized (discrete or narrow and thin line, whisker, strip) collecting regions wherein the distances between the current-collecting and current-pickup elements are comparable to the MCC diffusion range. Therefore, the inventive constructive solutions are suitable for a wide EMR band ranging from the visible portion to the invisible portion - above UV and below IR (near-IR, intermediate-IR and far-IR) radiation.

Therefore, the principally novel inventive features distinctive from all prior art PEC comprise: optimization of the distance between the collecting regions and/or the current-collecting electrode portions (and current-collecting buses). These distances are optimized to the values commensurable with the MCC diffusion range. At the same time, the collecting regions should be small in terms of lateral dimensions but may be quite long and extended, arranged as long thin line strips (separated from each other by a dielectric gap) or whiskers of any configuration and shape with two opposite current nodes. The collecting regions and current-pickup electrode portions may have any shape and configuration but should be provided discretely within a single SC structure (or separated by a dielectric gap) and their number should be large enough (at least 2 or at least 10 or at least 100 or at least 1.000 or at least 10.000, at least 1000.000, etc.). Therefore, the collecting regions are combined into a bunch or a current node by means of the current buses leading to a catastrophic increase in the conductivity of current through such converter.

In the PEC structures according to the invention, the shorter the distance between the current-collecting elements and current collectors is, the shorter the MCC lifetime is available for current collection. Therefore, in the SC according to the invention, the EMR conversion process is preferably localized for a better current collection and current pickup, i.e. the linear dimensions ofthe collecting regions with the p-n-junetions are reduced, and the distances between the current-pickup electrode regions are reduced to values commensurable with the MCC diffusion length. Alternatively, discrete collecting regions with vanishingly small point sizes or quite extended (long length) collecting regions shaped as line fiber whiskers (with small cross-sectional dimension) may be provided. Preferably, the cross-sectional dimension of the line whisker collecting regions and the cross-sectional dimension of the discrete collecting regions (across the width, in case of square configuration or diametrically in case of circular configuration) with the junctions should be less (preferably far less) than 50 $\mu$m. At the same time, separate p-n-junctions with the collecting regions should be provided. Alternatively, p-n-junetions should be also of a single type (substantially identical). At the same time, rather large N number of p-n-junctions is provided (preferably far more that one), i.e. N> 1 or N >> 1 (alternatively, N = 1 as well as N = 2 but preferably N - > $\infty$). In such structure, p-n-junctions with the collecting regions are combined into a bunch or a current node by means of electrodes (or their current-conducting portions). As a result of combining the current collectors into a bunch, the internal resistance of p-n-junctions is reduced to zero. Moreover, such optimization of the sizes of p-n-junctions with the collecting regions, of the width of the current-conducting buses and of the distances between the same also results in a surprising enhanced current collection effect found by the inventors - an abrupt increase in the converter short-circuit currents and open-circuit voltage.

In the experiments conducted by the inventors, shading of up to 30% by no means affected the efficiency of the current pickup, that is, with an increase in the shading level so did the SC short-circuit current. The collecting buses should be preferably of a minimum width commensurable with the dimension of the discrete p-n-junction with the discrete collecting region and the distances between the collecting regions and the distances between the current-pickup electrodes or buses are provided based on the canonical ratio formulated by the inventors for the distances between the collecting elements and buses as a PEC basic inequality:

$$F < 2f,$$

where f is a length of the diffusion range (or a diffusion length) of the non-equilibrium MC. This inequality is a necessary and sufficient condition for the PEC according to the invention. It is a substantial and principal distinctive feature of the PEC according to the invention over all those known in the art, which also forms the basis for an optimum charge collection and pickup in all SC structures according to the invention.

Alternatively, the F = 2f equality is possible.

However, this equality is just a necessary but not a sufficient condition for an optimum current collection by the MCC.

Preferably, the conditions of this inequality are further bounded so that the MCC with the least values of f may be involved in the current collection and pickup, i.e.

$$F << 2f,$$

Alternatively, the value of f may comprise a certain small quantity in excess of the diffusion length of the non-equilibrium minority charge carriers.

In general, the value of f in actual practice should be commensurable with the diffusion length of the non-equilibrium MC.

In practice, by means of size optimization of the p-n-junctions with the collecting regions and observance of the MCC diffusion range length limitations, as shown below, another surprising effect as applied to the inventive SC was found, namely, displacement of the spectral response maximum absorption towards the UV radiation and higher region and also towards the IR frequencies. At the same time, two new maximums are recorded within these regions - one in the cold spectral region and the other in the hot spectral region of the EMR, i.e. the converters according to the invention enable a substantial expansion of the convertible EMR.

When optimizing the sizes of the collecting regions and distances between the same, a transverse and longitudinal charge concentration gradient is suddenly registered, which is in further detail discussed below. The transverse MCC concentration gradient is generated, for example, by highly-doped deep first conductivity type regions on the first side of the second conductivity type substrate. The longitudinal gradient is formed by means of shading provided on the first or second side of the converter substrate using strip or grid or strip and grid current collecting-pickup buses. Thin and narrow strips are provided, and the grid cells of similar small dimensions should be provided.

The transverse and longitudinal MCC concentration gradient provides another surprising effect discovered by the present inventors, namely, an abrupt increase in the total diffusion current consisting of the quadrature-axis and direct-axis current components. At the same time, current increase from the direct-axis component of the diffusion current may be far in excess of that from the quadrature-axis one.

In order to create the transverse and longitudinal MCC concentration gradient, a system of artificial surface-bulk microinhomogeneities (abbreviated as SASBM) has been proposed by the inventors. The SASBM is formed by means of incorporation and combination within the surface structure of any inhomogeneities combined into a single current node and affecting the non-equilibrium MCC concentration gradient. In particular, this is achieved by breaking the integrity of the semiconductor substrate and by alternating therein of the collecting $n^+$ lasers or $p^+$ layers including creating of the local collecting regions of arbitrary shape and configuration ohmically related and not related to each other and to the collecting electrodes. A collecting $n^+$ or $p^+$ layer may be provided as a grid of discrete $K > 1$ (alternatively $K \gg 1$) small-sized regions or cells of an arbitrary shape and configuration or as a surface-distributed strip (comb) structure or as any discrete elements or extended thin whiskers (fibers). In general, any discrete element or a whisker-like region comprises a localized region of an arbitrary configuration combined into a single current node or bunch by electrodes.

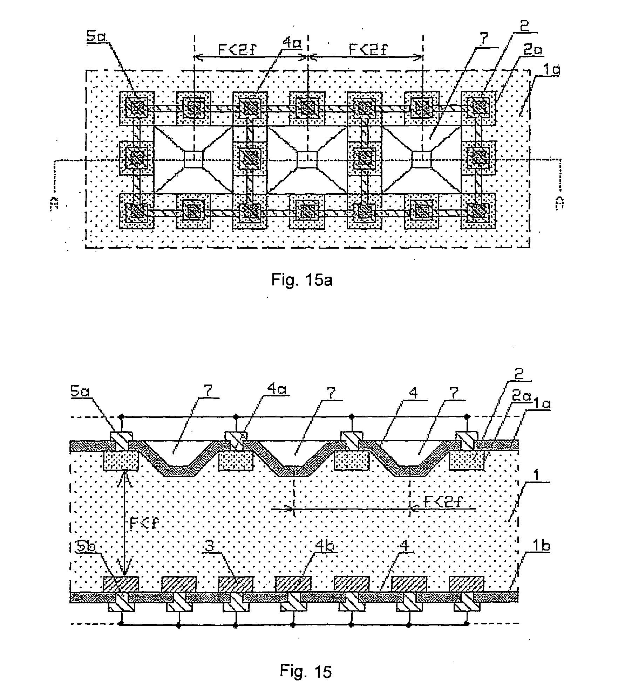

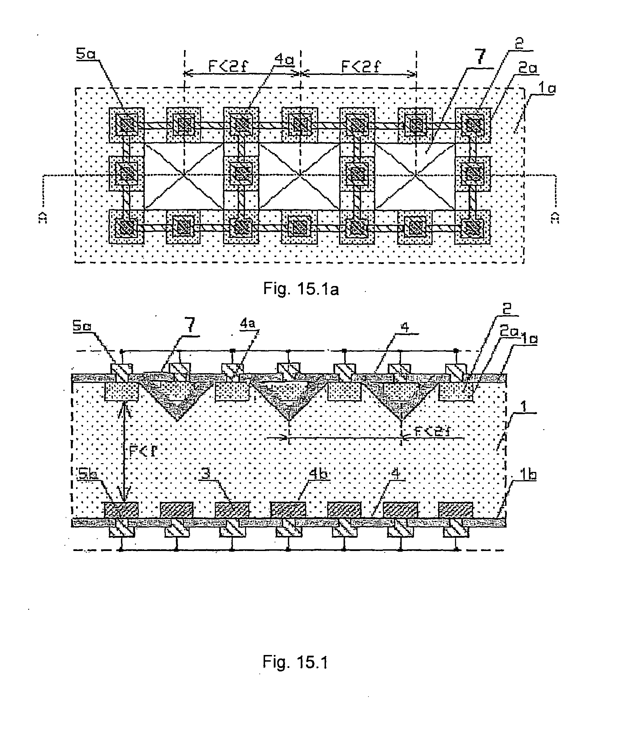

The SASBM is formed not only by alternating shaded portions of the current-collecting regions with the metallized buses but also by an EMR interference pattern within the semiconductor bulk, which is formed due to diffraction in the slits between current collectors and buses. In fact, precisely this structure of the bunched PEC comprises a diffraction grating to receive the incident EMR, and an interference pattern is formed within the semiconductor bulk, resulting in maximums, i.e. radiation concentration zones and minimums, i.e. radiation attenuation zones. Said maximums comprise zones where carriers are generated, while said minimums are zones of carrier drains between which a high concentration gradient dn/dx is registered enabling efficient separation of the non-equilibrium carriers. At the same time, the concentration of free carriers is significantly less in the drain zones than in the generation zones resulting in an increase therein both of the carrier mobility $\mu_n$ and lifetime $\tau_n$ due to a reduction in the scattering centers and recombination on the light-induced non-equilibrium carriers. When such PEC is heated, the diffusion factor $D_n$ (kT/q) $\mu_n$ of free carriers will increase leading to an increase in the diffusion current $j_n = qD_n$ (dn/dx) along with a temperature increase. The diffusion length $f_n = (D_n \tau_n)^{0.5}$ increases to enable collection of carriers from a larger PEC bulk. The incident radiation may be concentrated within the semiconductor bulk not only by means of a metallization system but also by providing inhomogeneities on the same semiconductor surface, for example, by surface etching to form a diffraction grating (Figs. 15-19) so that these inhomogeneities would comprise quantum traps on one side and surface concentrators on the other side. By coating the metallization and the semiconductor surface with a transparent layer whose interface with the environment creates a total internal reflection angle, the reflectivity of such system is minimized.

In the standard SC with a wide metallization pitch and texturing in the form of random surface asperities and valleys, when the behavior of waves in semiconductor depth is defined by the laws of geometric optics, no interference pattern is formed within the bulk. As the waves of the incident radiation become longer, a relatively negligible non-equilibrium MCC concentration levels off through the semiconductor bulk, i.e. (dn/dx)→0, and the diffusion current tends to zero which explains the spectral response of a standard silicon SC limited by the EMR length of $\lambda < 1\ \mu$m.

The flows of electrons and holes intersect in such PEC which results in the scattering of carriers not only thought the semiconductor structure and thermostimulated carriers but also among themselves whereby both the mobility and the lifetime is reduced. As the temperature increases, the short-circuit current and the open-circuit voltage of such PEC drops such that in actual practice their efficiency amounts to 50-30% of the rated efficiency, and at the temperatures of above 120°C such converters would come out of action.

The presence of optically stimulated generation zones and drain zones and their influence on the collector characteristics of the PEC according to the proposed SASBM model, is completely proved by the experimental data: at the levels of PEC shading by current collectors of up to 30%, the short-circuit currents decrease by not more than 8%; with the temperature increase to 70-100°C, the short-circuit current rises 1.2-1.4 times relative to current at 25°C; the open-circuit voltage of the discrete bunched PEC at 25-40°C is substantially constant and amounts to 0.9 relative to $U_{xx}|_{25c}$ at the operating temperatures of 40-70°C, which is determined both by a high value of photocurrent $I_\Phi$ and by a low value of saturation current $I_s$: $U_{xx} = (kT/q) \ln (I_\Phi/I_s + I)$. In other words, when interference zones are formed with the bulk of the bunched PEC, a temperature increase will result in an increased diffusion factor of the non-equilibrium MCC and increased diffusion length thereof.

Due to formation of the interference minimums and maximums within the semiconductor bulk of the inventive bunched PEC, which create an optically stimulated concentration gradient of the non-equilibrium MCC, built-in fields are generated in the direction of the current-collecting elements, i.e. a drift component of the photocurrent arises in addition to the diffusion component.

These phenomena account not only for a hyper-response of the bunched PEC in the experiments conducted by the inventors in the short-wave and long-wave bands, but also for the effect of a hyper-efficiency of the bunched PEC in the IR region when the currents of up to 1.2-1.5 with the voltages of up to 0.6 V have been collected over the region of 5.28 cm$^2$.

In general, the PEC surface may be configured as a diffraction grating, Franhoufer grating, grids, Fresnel lenses, etc. Diffraction centers may be formed within the semiconductor bulk as clusters, inclusions, etc., including but not limited to heterojunctions and nanoparticles. These are formed so that interference generation zones and drain zone of the non-equilibrium MCC are created within the semiconductor bulk (not randomly but for obtaining the interference pattern rather than just forcing the beam to envelope the screen or to expand to slits). Non-equilibrium MCC interference generation zones and drain zones are disposed within the range of diffusion lengths (rather than somewhere beyond the reach). At the same time, the light reflected by the semiconductor or metal will revert according to the total internal reflection law.

In a particular case, the SASBM is created by providing optimized shaded zones on the n$^+$ layer or p$^+$ layer of the converter in order to reduce the absorption region, on the one hand, and to enhance inhomogeneity, on the other hand, thereby increasing the value and the efficiency of the diffusive current component. It is desirable to provide shaded zones of minimum linear dimensions, for example, the current-conducting circuit or electrode portions arranged over the converter surface have a width tending to a sufficiently small value of δ being the dimension of the discrete n$^+$ region. A small value of the distance between the current-conducting buses F is also required, i.e. less that the doubled length of the MCC diffusion range (F < 2f) so that a charge at any location will have a range less than its diffusion range length. Shaded zones may comprise n$^+$ regions and p$^+$ regions, electrodes of collecting regions as well as any surface regions of the converter.

Shaded zones may be provided with any arbitrary configuration. It is preferred that the zones of inhomogeneities are of a single type, discrete and of minimum dimensions, combined into a single current node by means of the current-collecting electrodes. At the same time, these zone of inhomogeneities may have an arbitrarily-shaped configuration and their number may tend to G >> 1.

In a particular embodiment of the invention, for expanding the range of convertible frequencies from optically visible ones towards the short-wave and long-wave EMR frequencies and for reducing the MCC surface and bulk recombination, quantum trapping depressions may be provided with the current-collecting electrode portions arranged on their side surface to ensure trapping and absorption of photons over the SC surface and within its bulk. At the same time, it is essential for achieving the claimed technical effect that in all implementations of the inventive SC the ratio of dimensions of the collecting regions and distance between the same is observed with due account for the MCC lifetime and diffusion range.

Quantum traps may comprise pyramidal discrete depressions (including but not limited to the ones with truncated apex) arranged top end down (i.e. with their bases facing the respective converter surface). Depressions of any other geometry are possible. For example, the traps may be configured as vertical grooves (troughs) with a section in the form of an inverted trapezium (or tray). The distances between the traps with the current-collecting buses commensurable with the MCC diffusion length are provided.

Quantum traps are preferably positioned between the line strip (comb) current-collecting electrode (first and/or second) portions along the thin strips or comb teeth. The electrode portion strip (comb teeth) runs along the quantum trap on the converter first side (or second side) so as to partially cover the converter first side along the trap position and the lateral side of the groove throughout its length thereby providing for collection of charges from the converter surface, depth or bulk and hence eliminating surface and bulk recombination. The distance between the quantum traps is commensurable with the MCC diffusion length, i.e. meets the above PEC basic inequality F < 2f. Due to such design, the depth and region of penetration of the EMR high-energy short-wave spectrum portion into the semiconductor substrate is enhanced. At the same time, the deeper the quantum traps are, the more efficiently the short-wave quanta are captured within the converter bulk. Consequently, the deeper a quantum trap is, the more short-wave high-energy quanta are captured within the converter bulk and the more the number of the generated MCC and the higher the PEC efficiency is.

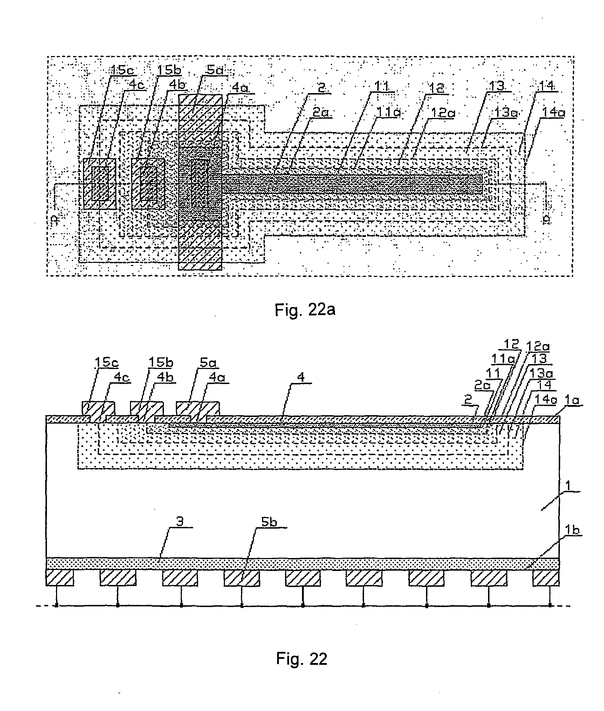

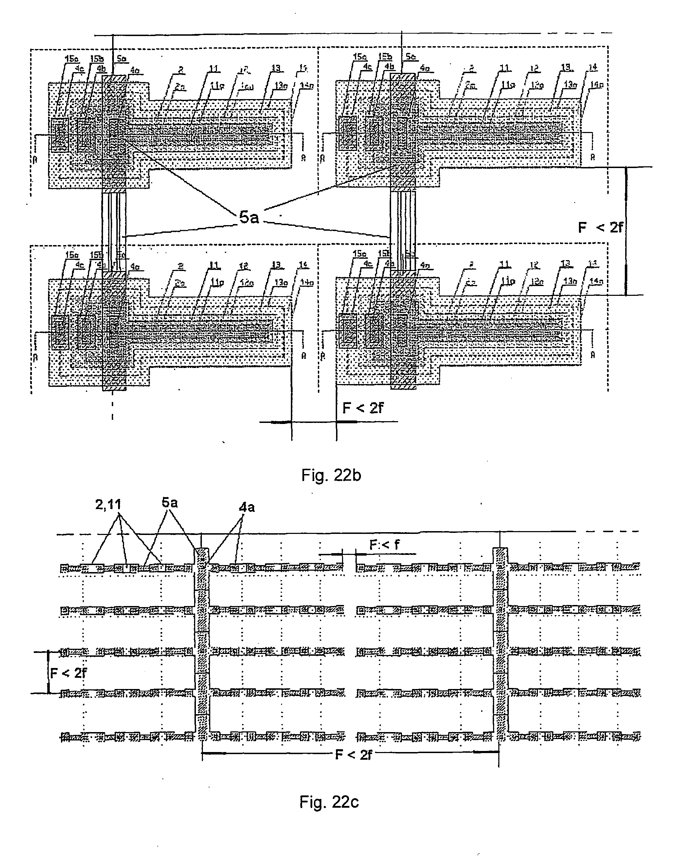

In a particular case, the efficiency and expansion of the convertible EMR range may be provided by means of a multilayer (multijunction) structure of progressively switched p-n-junctions (Figs. 22a-22). In fact, such multilayer stack comprises an open-circuit voltage multistage multiplier. In such converters, a series of layers is formed by successive doping, each pair of which, when progressively switched, increase the open-circuit voltage approximately by the contact voltage drop value. W > 1 of multilayer stacks are contained in a single cell of such converter. Therefore, W > 1 of multilayer stacks are connected in a single converter cell into a parallel (internal rather than external) circuit, i.e. combined into a current node (Figs. 22b-22c). A particular case is possible wherein W = 1, but it is less preferable. At the same time, the absorption of the incident EMR is significantly enhanced in the converter with such design due to a large share of vertical p-n-junctions. Moreover, additional doped layers provide no optical barrier to the short-wave spectrum region due to their discreteness. In addition, such converter will operate within the entire EMR range.

In practice, the inventive SC made of conventional semiconductor materials like silicon operate within a wide range of EMR frequencies form the FM to the high-energy UV band, roentgen band and higher bands when the EHP conversion process is localized by reducing typical dimensions of the collecting regions and current collectors to an infinitely small value (to d - > ISV) and by increasing their number to an infinitely large value (to X - > ILV).

A superconductivity effect, i.e. a catastrophic reduction in p-n-junction resistance essentially to zero, may be achieved in the converter by providing N sufficiently small and deep doped first conductivity type (alternatively, second conductivity type) regions along with formation of a number of p-n-junctions (alternatively, their number is preferably far in excess of one, i.e. N >> 1) spaced apart at F < 2f, followed by combining said N discrete regions into an bunch or a current node (at N > 1 and N >> 1) by means of the current-collecting electrode. For enhancing said effect, it is appropriate to further reduce the linear dimensions of the junctions with the collecting regions (d - > 5, where 5 is an infinitely small value, ISV) and to increase their number to N >> 1 (ideally, N - > ∞, where ∞ is an infinitely large value, ILV), to make them as single-type elements, i.e. substantially identical as to dimensions, configurations, and other process characteristics. Reduction in the internal resistance of the p-n-junction results in strengthening of their internal field whereby current collection ultimately improves due to an increase in the MCC motion speed and diffusion range.

It should be noted that the scale effect of the resistance drop to zero is present only in a statistical sample with small-sized elements comprising p-n-junction with the collecting regions. At the same time, at least one element in such statistical sample with vanishingly small-sized elements should have a zero resistance value. As experimentally shown by the inventors, in case of the statistical sample of at least 100 resistances given sufficiently small dimensions, at least one clement has a zero resistance value. When said elements are combined into a bunch or a current node, the scale effect of the abrupt resistance drop to zero occurs. This is due to the fact that when Z resistances are connected in parallel, the total resistance according to the parallel connection and shunt law will have a value of less than the least value. And if at least one element in such circuit has a zero value, the total resistance will also have a zero value. However, it should be noted that the main distinction of the present invention over the prior art lies in an optimum current collection whose effect has been discovered and identified only within the scope of the present invention. Other prior art methods for PEC optimization are applicable in this invention, but all such structures are distinguished over the prior art in that distances between current collectors meet the above PEC basic inequality, i.e. $F < 2f$.

In another particular case, to provide the MCC diffusion range in the inventive SC structures the MCC motion speed is increased by accelerating the same with additionally built-in internal fields. This can be done technically by including additional deflecting $n^+$ or $p^+$ regions into the SC substrate structure by doping and/or by including field-effect electrodes just as in MOS capacitors or transistors. Deflecting regions and bias voltage supply either enhances or weakens the MCC generation and recombination processes. Therefore, generation-recombination processes in the inventive SC can be controlled and adjusted so that one may, if desired, either increase or reduce the energy conversion efficiency of the solar cells.

As it will become obvious from the following disclosure, other particular embodiments of the invention are also possible, wherein techniques known in the art may be used for improving the SC operational performance, with said embodiments also being within the scope of the legal protection sought for. The essence of the invention will be further explained in more detail by specific examples of its embodiment discussed with reference to the accompanying drawings. As used herein, the following terms, abbreviations and notational conventions will have the following meaning:

EMR is understood as electromagnetic radiation able to generate non-equilibrium minority charge carriers in the converter;

Substrate is understood as a plate of any semiconducting material, wherein the converter elements are formed. As an example, a p-conductivity type silicon substrate is disclosed herein;

First side (FS), second side (SS) is understood as the sides of the semiconductor substrate or converter, which may be subject to the EMR exposure or irradiation;

Photoelectric converter (PEC), photovoltaic cell (PVC), solar cell (SC), converter is understood as a semiconductor device which converts the EMR into electric current and photo-EMF;

Converter element is understood as a converter component, converter portion (region) with common functionality;

Collecting elements, collecting regions are understood as doped portions (or regions) of the converter forming p-n-junctions together with the substrate which ensure current collection by MCC and are in contact with external electric circuits; collecting regions may comprise continuous, discrete, line, whisker, extended (uninterrupted) long-length converter elements of small lateral dimensions;

Deflecting elements, deflecting regions are understood as doped portions (or regions) of the converter forming and not forming p-n-junetions together with the substrate and enabling deflection of MCC;

Electrode, bus, contact is understood as a portion of the current-conducting circuit of a current-conducting material adjacent to deflecting and collecting regions and ensuring current collection and pickup into external electric circuit;

Field-effect electrodes, control electrodes are understood as electrodes to which the electric potential is applied;

Discrete p-n-junction (or portion or region) is understood as a discontinuous small-sized converter element; discontinuous p-n-junction, portion or region of small thickness, width, length, diameter;

Diffusion converter is understood as a converter based on diffusion current;

Diffusion-drift converter is understood as a converter based on diffusion and drift current.

In view of the state ofthe art [RU 2,284,267 C2, 10.11.2004;

Kartashov E.M., Tsoi B., Shevelev V.V., The Structural and Statistical Kinetics of Polymer Destruction, Moscow, Khirnia Publishers, 2002, 736 pages;

Tsoi B., Lavrentiev V.V. Kartashov E.M., Shevelev V.V., Electroinsulating Material // RU 2,284,593, 26.10-2004], as used herein, a statistical bunch (or statistical stack) or simply bunch should be understood as a multi-element statistical structure formed of $N > 1$ (where N is an integer) separated single-type individual constituent resistive elements (in this case, resistances p-n-junctions with the p- and n-regions adjacent thereto) assembled into a parallel electric circuit and combined by means of a conductor (common electrode) into a single bunched current node. Accordingly, a converter comprising a large number of junctions combined into a current node or bunch is referred to as a bunched converter.

Furthermore, the term "single-type" should be understood as p-n-junctions made in the same manner (in the same conditions) of the same materials (using the same dopes in the same concentrations) and having substantially the same geometrical dimensions, configuration and shape as well as the same structure-sensitive physical (mechanical, electric, electromagnetic and other) characteristics and properties. The uniformity of p-n-junctions is a necessary criterion (i.e. equivalent) of the uniformity of the first conductivity type regions (p- or n-regions). Similarly, the term "single-type portions" of the first electrode should be understood as the elements of this electrode made in the same manner of the same material (of which the first electrode itself is in fact made) and having substantially the same dimensions, and shape as well as substantially the same structure-sensitive physical (mechanical, electric, electromagnetic and other) characteristics and properties. The term "single-type" is used herein because due to tolerances for individual parameters of the final product present in any process, it is highly improbable in practice that all p-n-junctions or all said elements of the first electrode are absolutely identical although it is preferable.

Moreover, "separate" p-n-junctions should be understood as p-n-junctions with no intersecting or overlapping portions, i.e. each of the p-n-junctions is provided apart (Separately) from the other p-n-junctions in the converter. It is in fact equivalent to the apartness (severalty) of said regions having the same conductivity. Similarly, "separate" elements of the first electrode mentioned above should be understood as elements with no intersecting or overlapping portions which is ensured by providing either an oxide gap (in particular, an oxidized portion of the electrode) between these elements or through holes (partial recesses in the first electrode between said elements).

It is a principally novel feature essential for all converter designs according to the invention and distinctive over the prior art that the p-n-junction with the collecting regions (elements) and current collectors adjacent thereto are spaced apart from each other at intervals of less than the doubled diffusion length of the non-equilibrium MCC, with all of them being combined into a current node or bunch and therefore referred to as bunched based on this feature.

BRIEF DESCRIPTION OF THE DRAWINGS

Fig. 1 shows a detail of the sectional view of the double-sided bunched converter with discrete collecting regions 2,
Fig. 1a shows a detail of the sectional view of the double-sided bunched converter with strip-line collecting regions 2,
Fig. 2 shows a detail of the bottom view of a first side of the double-sided bunched converter with discrete collecting regions illustrating the strip (comb) current-collecting pickup bus 5a,
Fig. 3 shows a detail of the bottom view of a first side of the double-sided bunched converter with discrete collecting regions illustrating the strip (cross-shaped) current-collecting pickup bus 5a,
Fig. 4 shows a detail of the strip-line current-collecting pickup bus 5a of the "tooth-into- tooth" type,
Fig. 5 shows a detail of the grid current collection strip pickup bus 5a of a variable longitudinal section for reducing the shading level,
Fig. 6 shows a detail of the strip-line current-collecting pickup bus 5a of a variable longitudinal section for reducing the shading level and provided with strip-line collecting regions 2,
Fig. 7 shows a detail of the strip pickup bus 5b on a second side of PEC,
Fig. 8 shows a detail of the cross-shaped strip current-collecting pickup bus 5a with the line collecting region 2 provided under the bus 5a and being completely shaded,
Fig. 9 shows a detail of the cross-shaped strip current-collecting pickup bus with the extended half-closed deflecting elements 6, illustrating the cross-shaped collecting region 2 provided under the bus 5a and being completely shaded,
Fig. 10 shows a detail of the cross-shaped strip current-collecting pickup bus with the extended half-closed deflecting elements 6, illustrating the collecting region 2 being partially exposed and partially positioned under the bus 5a,
Fig.11 shows a detail of the cross-shaped strip current-collecting pickup bus with extended half-closed deflecting elements 6, illustrating the collecting region 2 shown as discrete small squares under the bus 5a and being completely shaded,
Fig. 12 shows a detail of the cross-shaped strip current-collecting pickup bus with the discrete deflecting elements 6, illustrating the collecting region 2 shown as discrete small squares under the bus 5a and being completely shaded,
Fig. 13a shows a detail of a first side of the double-sided bunched converter with the continuous collecting region 2 and strip-line current-pickup bus 5a,

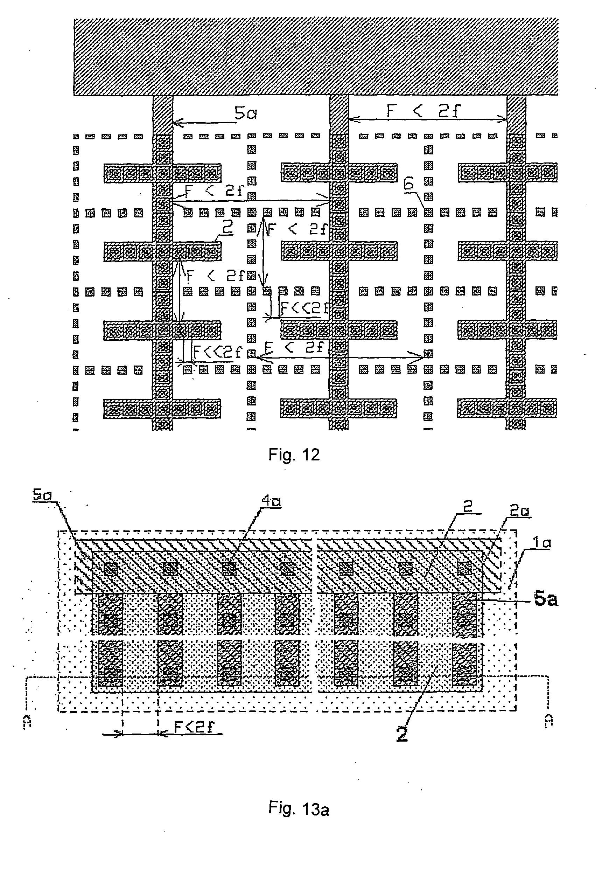

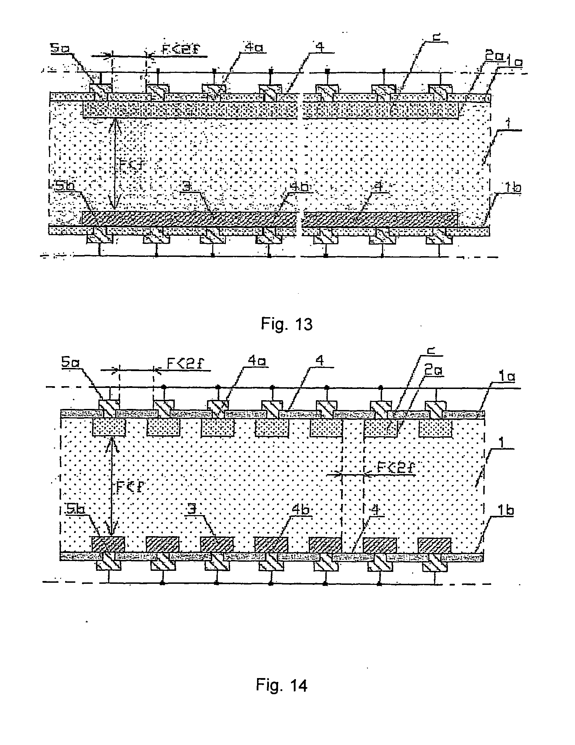

Fig. 13 shows a detail of the sectional view along line A-A in Fig. 13a of the double-sided bunched converter with the continuous collecting $n^+$ region 2, strip-line current-pickup bus 5a and continuous deflecting $p^+$ region 3,
Fig. 14 shows a detail of the sectional view of the double-sided bunched converter with discrete collecting regions and highly-doped deflecting elements,
Fig. 15a shows a detail of a first side of the double-sided converter with quantum traps in the form of the reversed truncated pyramid 7,

Fig. 15 shows a detail of the sectional view along line A-A in Fig. 15a of the double-sided converter with quantum traps in the form of the reversed truncated pyramid 7,

Fig. 15.1a shows a detail of a first side of the double-sided converter with pyramidal quantum traps 7.

Fig. 15.1 shows a detail of the sectional view along line A-A in Fig. 15.1a of the double-sided converter with pyramidal quantum traps 7,

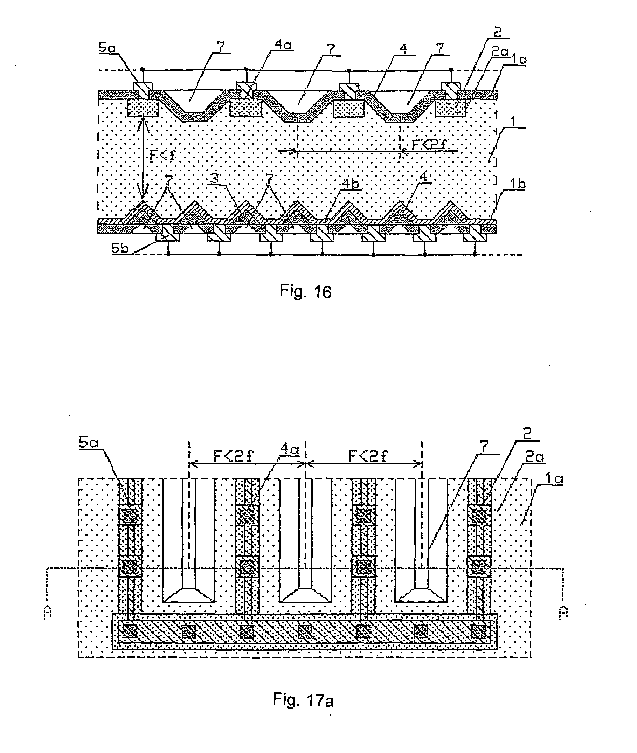

Fig. 16 shows a detail of the double-sided converter with pyramidal quantum traps provided on both sides,

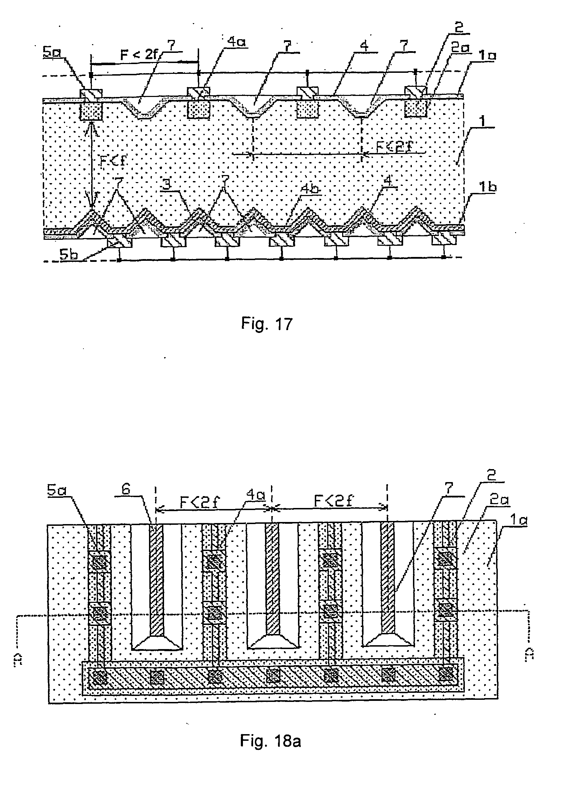

Fig. 17a shows a detail of the double-sided converter with the "aqueduct"-like quantum traps (on the first side).

Fig. 17 shows a detail of the sectional view along line A-A in Fig. 17a of the double-sided converter with the "aqueduct"-like quantum traps (on the first side) and "pyramid"-like quantum traps (on the second side),

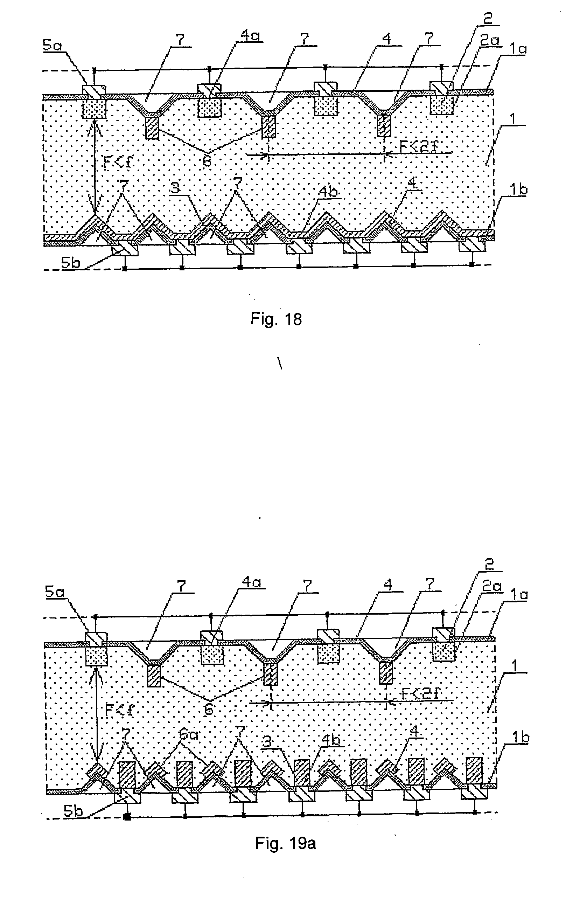

Fig. 18a shows a detail of the first side of the double-sided converter with the deflecting elements and quantum traps,

Fig. 18 shows a detail of the sectional view along line A-A in Fig. 18a of the double-sided converter with the deflecting $n^+$ elements 6 and "aqueduct"-like quantum traps (on the first side) and grooved delta-shaped quantum traps (on the second side), with continuous deflecting $p^+$ layer 3 being provided,

Fig. 19a is a first embodiment 1 showing a detail of the sectional view of the double-sided converter with the deflecting $n^+$ elements 6, $p^+$ elements 6a and "aqucduct"-like quantum traps (on the first side) and "pyramid"-like quantum traps (on the second side), with discontinuous and deep deflecting $p^+$ elements 3 and 6a being provided,

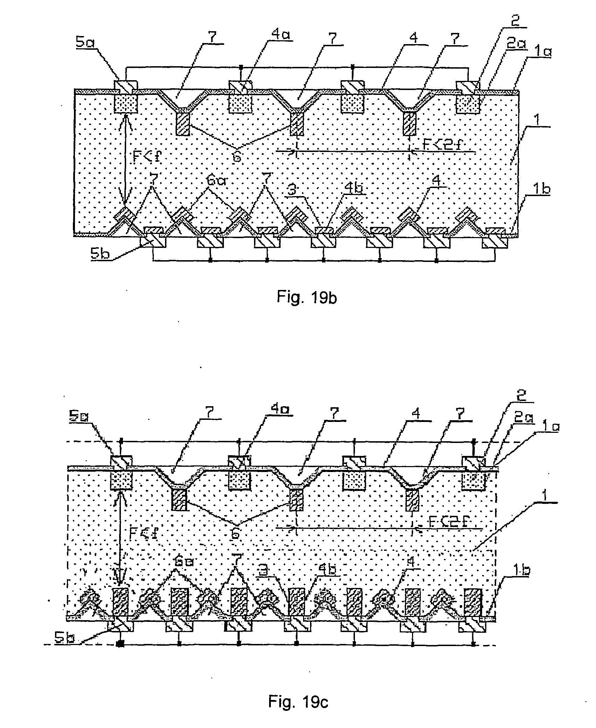

Fig.19b is a second embodiment showing a detail of the sectional view of the double-sided converter with the deflecting $n^+$ elements 6, $p^+$ elements 6a and "aqueduct"-like quantum traps (on the first side) and "pyramid"-like quantum traps (on the second side), with discontinuous deflecting $p^+$ elements 3 and 6a being provided,

Fig. 19c is a third embodiment showing a detail of the sectional view of the double-sided converter with the deflecting $n^+$ elements 6, $p^+$ elements 6a and "aqueduct"-like quantum tramps (on the first side) and "pyramid"-like quantum traps (on the second side), with discontinuous deflecting $p^+$ elements 3 and 6a being provided and the regions 2 and 3 being oppositely,

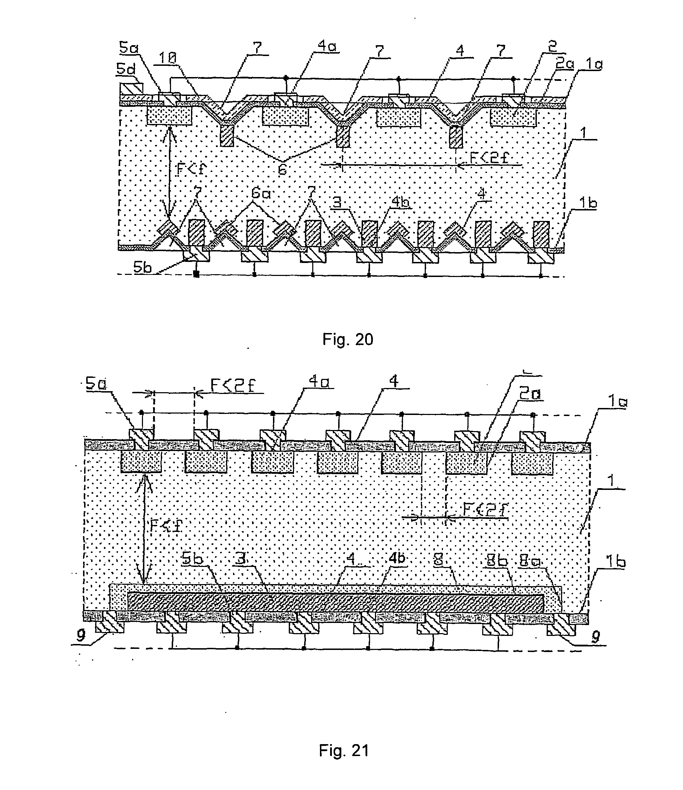

Fig. 20 shows a detail of the double-sided converter with the field-effect control electrode 10, discrete deflecting elements 3, 6-6a and quantum traps 7, with the metal contact 5d being electrically connected to the field-effect electrode 10,

Fig. 21 shows a detail of the sectional view of the double-sided bunched converter with the discrete collecting regions 2 (on the first side) and multistage open-circuit voltage multiplier (on the second side), with the number of multiplication stages being of $N_\kappa = 2$, wherein the second conductivity type region 3 in said voltage multiplier is created in the first conductivity type region 8 forming the p-n-junction 8a with the substrate 1, said junction 8a being short-circuited by the metal bridge 9, and the p-n-junction 8b formed by the regions 3 and 8 forms a diode increasing the converter open-circuit voltage,

Fig. 22a shows a detail of the double-sided converter with the multistage open-circuit voltage multiplier (on the first side),

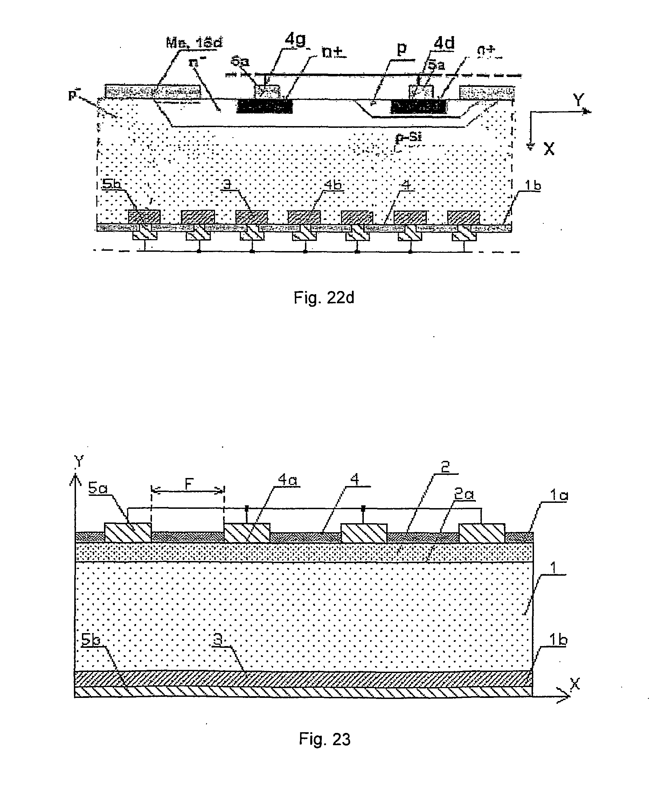

Fig. 22 shows a detail of the sectional view along line A-A in Fig. 22a of the double-sided converter with the multistage open-circuit voltage multiplier (on the first side) and the continuous deflecting layer 3 (on the second side), said multistage multipliers comprising a series of opposite conductivity type layers, wherein, for example, in the p-type substrate 1 there is formed the n-typa doped layer 14 wherein the p-type layer 13 is formed, wherein the n-type layer 12 is formed, wherein the p-type layer 12 is formed, and so on. These layers form a series of p-n-junctions 2a. 11a, 12a, 13 a, 14a, etc. The junctions 11a, 13a may be short-circuited by means of metallization 15b, 15c through the contact windows 4b, 4c. The collecting element 2 is connected through the contact window 4a in the dielectric 4 to the current-collecting bus 5a via which the multistage elements become combined,

Fig. 22b is an embodiment showing a detail of the first side of the double-sided converter with the multistage open-circuit voltage multiplier (on the first side) and an embodiment showing the "head-to-end" connection of the converter elements,

Fig. 22 is an embodiment showing a detail of a first side of the PEC with photomultipliers, illustrating an exemplary connection of elementary multiplier unit arranged into a series circuit with a current node,

Fig. 22d shows a detail of the three-stage double-sided converter,

Fig. 23 shows a conventional photoelectric converter,

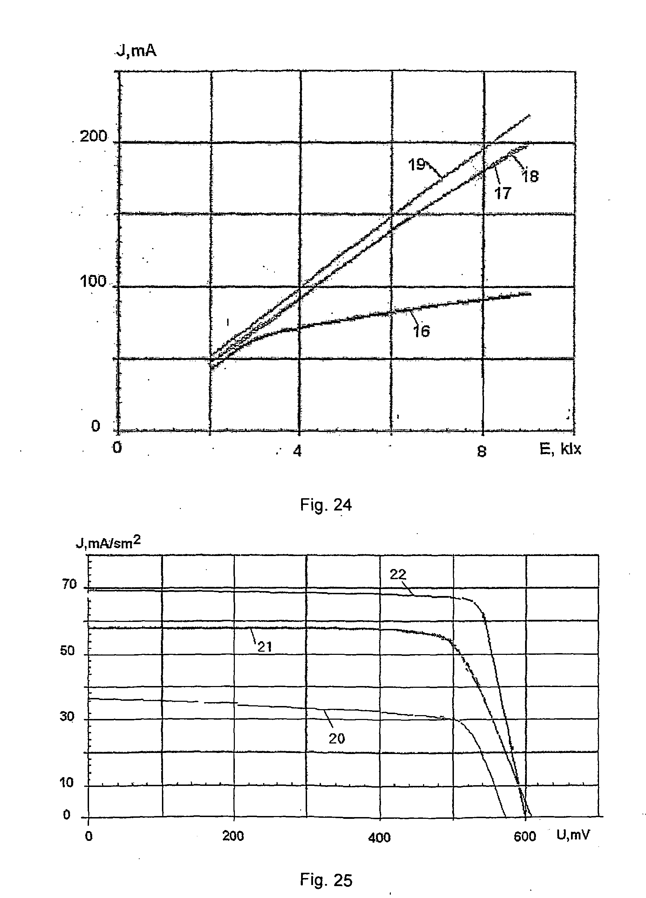

Fig. 24 shows the relation of the short-circuit currents and the illumination intensity (using a 300 W incandescent lamp) for a 24x22 mm test SC according to the invention,

Fig. 25 shows the current-voltage relationship (CVR) of a control SC (20) and the inventive SC with different distances between the current-collecting buses of F < 2f (22) and F - 2f (21),

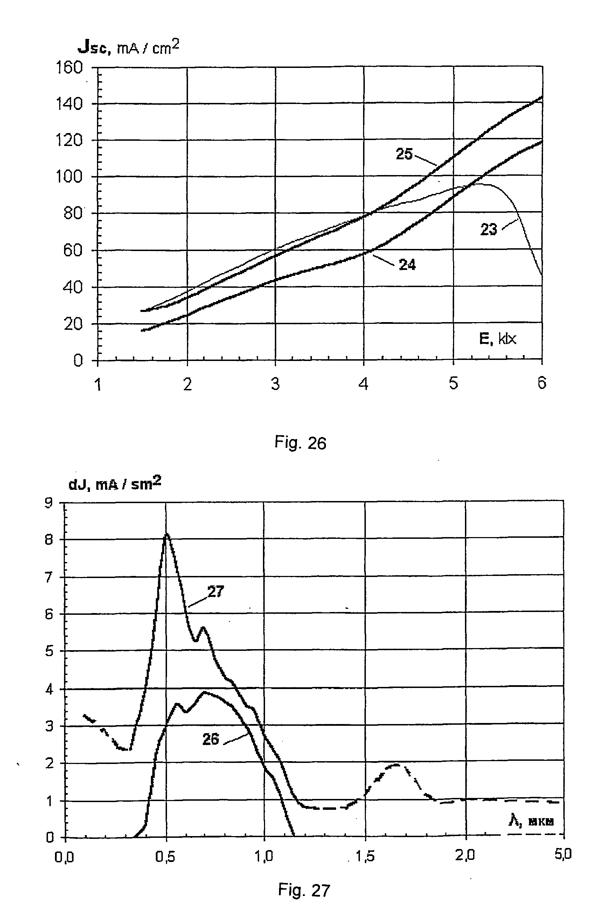

Fig. 26 shows the relation of current density and the solar cell illumination intensity within the IR range being of 0.900 to 200 $\mu$m,

Fig. 27 shows the relations of the incrementing short-circuit current densities and the electromagnetic wavelength for the standard continuous silicon SC 26 and for the bunched diffusion SC 27 according to an embodiment of the invention,

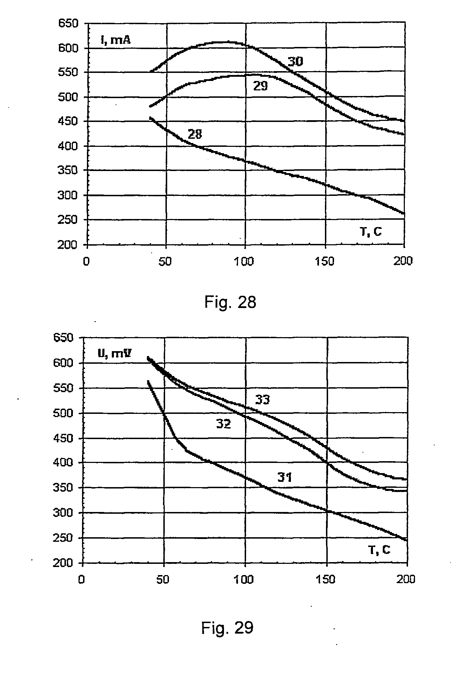

Fig. 28 shows the influence of the IR radiation ($\lambda$ = 0.900-200 $\mu$m) and temperature on the short-circuit currents for the control standard PEC (curve 28) and for the inventive SC according to various embodiments (curves 29, 30),

Fig. 29 shows the influence of the IR radiation ($\lambda$ = 0.900-200 $\mu$m) and temperature on the open-circuit voltage for the control standard PEC (curve 31) and for the bunched PEC according to the invention (curves 32, 33).

The reference numerals in the drawings show:

1 - substrate; a plate of any semiconductor material;

1a - first side ofthe substrate or converter (FS);

1b - second side of the substrate or converter (SS);

2 - $n^+$ collecting elements (long-length, line, whisker or discrete doped current-conducting regions, portions);

2a - p-n-junction;

3 - deflecting region and $p^+$ collecting element; an region with the same conductivity as that of the substrate but with a higher doping level for providing current collection by the MCC on the SS;

4 - dielectric material; a dielectric layer transparent to the EMR, for example, silicon nitride;

4a - electric contact of the FS to $n^+$ collecting elements 2; window in the dielectric 4 for providing electric contact of elements 2 to 5a;

4b, 4c -electric contacts; windows in the dielectric 4 for providing electric contact of elements;

5a - first current-conducting collecting and pickup electrode, Me (metal) to the FS; metal electrode to the element 2 for providing contact with external electric circuits;

5b - second (on the second side) current-conducting collecting and pickup electrode, Me (metal) to the SS $p^+$ region 3; metal electrode to the element 3 for providing contact with external electric circuits;

5d - field-effect electrode metal contact;

6a - $n^+$ deflecting element (region);

6 - FS $p^+$ deflecting element (region); converter portions with a high doping concentration relative to the substrate, forming no p-n-junetions with the substrate and providing no current collection for the non-equilibrium charge carriers;

7 - discrete quantum trap; quantum trap shape as a tray (groove);

8 - first $n^+$ conductivity type region in the voltage multiplier;

8a-voltage multiplier p-n-junction formed by regions 1 and 8;

8b - voltage multiplier p-n-junction formed by regions 3 and 8;

9 - interlayer metal bridge for short-circuiting of p-n-junctions;

10-expanded polysilicon (Si*) field-effect electrode;

11 - second conductivity type p-layer in the voltage multiplier;

11a - voltage multiplier p-n-junction formed by regions 11 and 12;

12 - first conductivity type n-layer in the voltage multiplier;

12a-voltage multiplier p-n-junction formed by regions 12 and 13;

13 - second conductivity type p-layer in the voltage multiplier;

13a - voltage multiplier p-n-junction formed by regions 13 and 14;

14 - first conductivity type n-layer in the voltage multiplier;

14a voltage multiplier p-n-junction formed by second conductivity type regions 1 and 14;

15b - interlayer metal bridge for short-circuiting of p-n-junction 11a;

15c - interlayer metal bridge for short-circuiting of p-n-junction 13a.

By way of explanation of the invention, a table is provided below wherein the values of short-circuit current and open-circuit voltage are given for SC depending on different EMR conditions.

Table

| SC type | Open-circuit voltage, V | Short-circuit current, mA | EMR source or type |
|---|---|---|---|
| Inventive SC | 0.75 | 36 | Roentgen, $\lambda$ = 5 nm, $10^6$ imp./s |
| Standard control SC | 0.00 | 0.00 | Roentgen, $\lambda$ = 5 nm; $10^6$ imp./s |
| Inventive SC | 0.600 | 100 | UV rays, $\lambda$ = 230 nm, 2,000 1x |
| Standard control SC | 0.00 | 0.00 | IR rays, $\lambda$ = 900-200,000 nm; T = 473 K |
| Inventive SC | 0.560 | 900 mA | IR rays, $\lambda$ = 900-200,000 nm; T = 473 K |

(continued)

| SC type | Open-circuit voltage, V | Short-circuit current, mA | EMR source or type |
|---|---|---|---|
| Standard control SC | 0.00 | 0.00 | 100 W incandescent lamp, 2000 1x + IR rays, $\lambda$ = 900-200,000 nm |
| Inventive SC | 0.46 | 17 mA | 100 W incandescent lamp, 2000 1x + IR rays, $\lambda$ = 900-200,000 nm |
| Notes to Table 1: the measured SC photosensitive surface area is 24 mm x 22 m, | | | |

PREFERRED EMBODIMENTS OF THE INVENTION

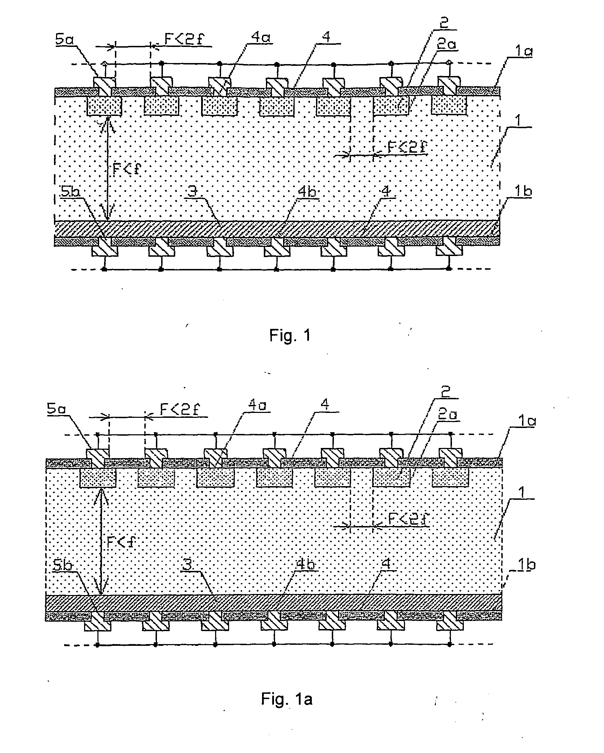

The diffusion bunched double-sided SC of the invention may be made both by the method for producing SC and by the standard semiconductor technology using the semiconductor materials with due account for constructive solutions depicted in Figs. 1-22d. For simplicity, only details of the sectional views of the structure diagrams and their views seen from the first and second sides are shown in the figures of the drawings. Moreover, the first conductivity type will be hereinafter for simplicity understood as n-conductivity type, and the second conductivity type - as p-conductivity type although it is clear that in certain particular cases a reverse embodiment is possible (wherein the first conductivity type means p-conductivity, and the second conductivity type means n-conductivity).

Example 1. Double-sided bunched converter with discrete collecting regions.

Fig.1 shows one the proposed embodiments of the diffusion PEC with N discrete current-collecting regions 2 and p-n-junctions 2a.

On a first (upper, directly exposed to the EMR) side of the substrate 1a (in particular, of single-crystal silicon having a second conductivity type, i.e. p-conductivity due to the dopes, for example, trivalent boron embedded therein), by screen printing or other known methods including but not limited to photolithographic printing methods traditional for the semiconductor engineering (using photolithographic masks) windows are exposed in the masking dielectric, for example $SiO_2$, wherein the first conductivity type (n-conductivity) dope is introduced. As a result, N separate first conductivity type collecting regions 2 of a single-type in terms of composition, dimensions and other characteristics are formed on the first substrate side 1a. These N separate single-type first conductivity type collecting regions 2 together with the substrate 1a material form N p-n-junctions 2a. On the second substrate 1a, highly-doped continuous $p^+$ layer 3 is provided in the same manner.

In contrast to traditional solutions known in the art, instead of the continuous first conductivity type collecting $n^+$ layer, alternating discrete and small enough (N >> I) $n^+$ regions and $p^+$ regions are provided in such converter as said layer, with the second p-conductivity type (basis conductivity of the substrate) regions being left on the first side 1a to form EMR transmission bands and to allow the short-wave portion of the incident radiation access into the converter bulk.

Depending on the constructive solution, various configurations for the first conductivity type regions 2 may be provided: squared, circular, cellular, meander, globular or any other. These regions 2 are preferably of a single type, i.e. are substantially identical.

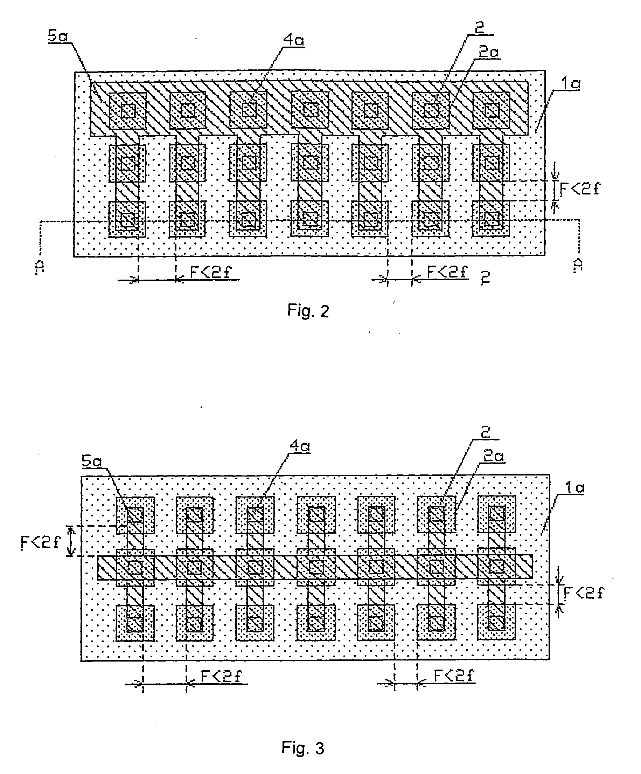

The single-type regions 2 are preferably isolated from each other by the oxide or other isolating layer 4 which may comprise traditional antireflection coatings. The collecting regions 2 have adjacent contacts 4a which are connected to the line portions of the first (upper) electrode 5a and are preferably completely covered by these portions in the embodiments, for example, shown in a Figs. 2 and 3 (however, other embodiments of the buses are possible).

Advantageously, the collecting regions 2 and the strip portion of the first electrode has a width of less than 50 $\mu$m, and in a preferred case the width should be reduced to negligibly small values, i.e. to the acceptable dimensions considering the photolithographic printing resolution given the current state of the art (or to still smaller dimensions when using a different high-precision printing method with a higher resolution).

In various particular cases, the first electrode portions and the collecting regions 2 may have line, strip-grid, grid configurations, with the discrete collecting regions 2 possibly being completely shaded by the first electrode portions. However, the distance between the strip portions of the first electrode and the distance between the discrete collecting regions 2 (and junctions 2a) in all instances comprises the value of F, commensurable with the MCC diffusion length, i.e, meets the condition of F < 2f. The strip-line portions 5a are preferably combined into a bunch or a current node by a transverse backbone bus which in turn may have a bunched structure, i.e. may consist of a number of thinner constituent strips.

Each first conductivity type collecting region 2 may be converted into a separate current node by differentiation.

Node derivatives may be also differentiated until the resolution limit of the current lithographic printing is reached. The higher the differentiation level is, the lower the resistance in the current node is and the higher the PEC efficiency is.

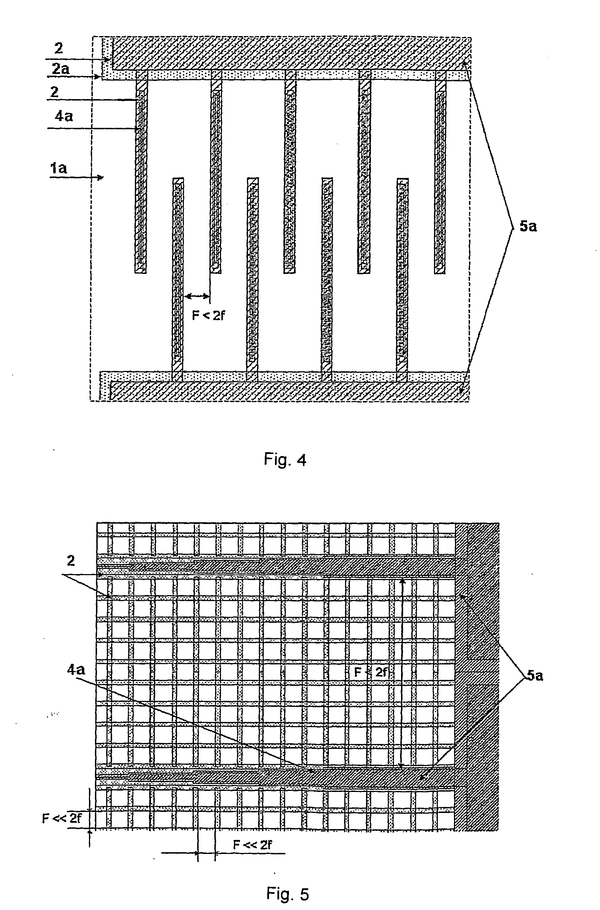

The current-conducting collecting portions of the first electrode and/or collecting regions 2 may have a different arrangement, for example, of the "strip-into-strip" type (or "tooth-into-tooth") as shown in Fig. 4, or may be arranged as a grid with separate single-type cells as shown in Fig. 5. At the same time, the maximum lateral dimension F of the cell is provided to be far less than the diffusion length f, i.e. the inequality F << f has to be met. In the structure of Fig.5, it is shown that the portions 5a of the first electrode are needle-shaped and have a variable longitudinal section for reducing the shading level.

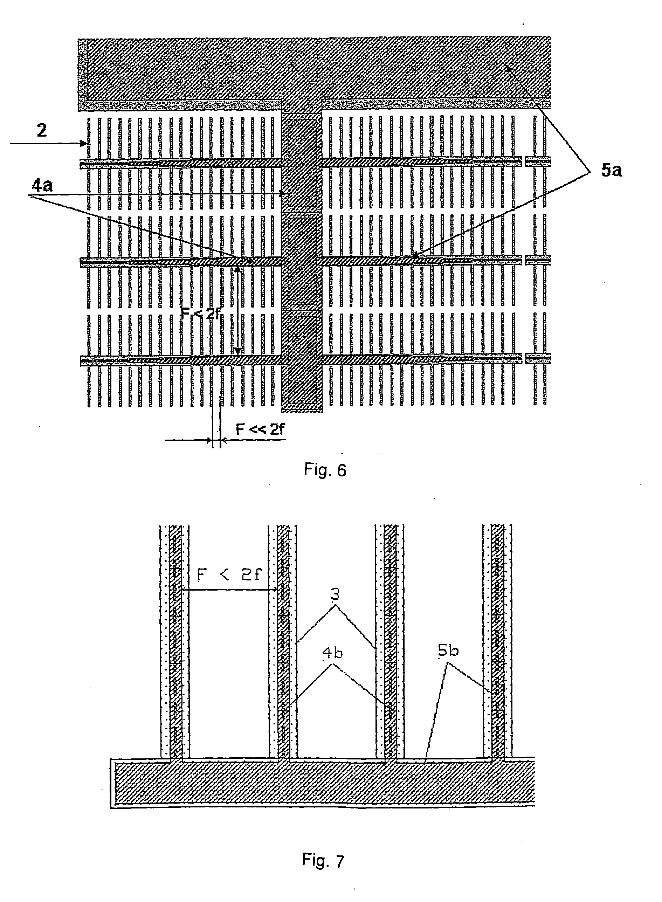

Fig. 6 also shows a strip contact system with line or "whisker-shaped" collecting regions 2 (i.e. with a combination of longitudinal and transverse regions 2) as well as with ncedle-shaped buses 5a having a variable section (or tapering) along the length towards the edges for reducing the shading level as shown in Fig. 5. The distance F between the collecting elements 2, has to be far less than the diffusion length f in the same manner as in the previous structure, i.e. the inequality F << 2fhas to be met.

In all such structures, reduction of the electrical resistance and realization of the current node, i.e. the bunch effect is ensured.

The distances F between separate single-type p-n-junctions with the collecting regions in this structures depending on the embodiment should meet the basic inequality for PEC: F < 2f or F << 2f, where f is a diffusion length of the MCC. In the general case, the distances between the current pickup buses adjacent to the collecting regions 2 also satisfy the general inequality (1) for PEC.

Furthermore, on the second substrate side, contracts 4b are exposed, for example, by photolithographic printing and strip or line portions of the second electrode 5b are formed with the current-conducting buses for providing contact with the external electric circuits. Similarly to the electrode 5a, the electrode system 56 is preferably arranged as strips in various embodiments and structures shown in Figs. 2-6, with the distances between the buses being of F < 2f and F << 2f.

Therefore, the second electrode 5b like the first electrode 5a is combined into a single current node, i.e. it has a bunched structure ensuring a minimum internal resistance of the contact system. However, the main distinction ofthe inventive PEC consists in negligibly small distances between the current collectors allowing MCC with negligibly small lifetimes to be collected. Creation of transverse and longitudinal charge concentration gradient (for example, by partially shading the converter sides against the EMR) makes it possible to perform current collection within a wide range of the EMR from the long-wave region including millimetric and lower frequencies and to a rather long-wave region including the UF and higher frequencies.

Therefore, the current-collecting and contact system structure (including collecting regions and current-collecting electrodes) comprises the principal and most important factor in achieving the technical effect of the inventive PEC. For any converter structure and configuration of the current-collecting and current pickup elements, their relative position (proposed now or in the future) is provided such that they are spaced apart at a distance commensurable with the MCC diffusion length, i.e. relations F = f, F = 2f, F < f, F 2f or F << 2f have to be satisfied. As MCC are formed under the influence of the incident EMR, it is required that the nearest current collector is provided at a distance not exceeding, preferably less than the length of its diffusion range (hence, the distance between the current collectors themselves should be less than the doubled MCC diffusion length) so that the charge during its lifetime will have time to reach the collecting element and pass to the external circuit. Therefore, good electroconductive properties are required in the current-conducting collectors, contacts and buses. This requirement is met in the invention by providing the current-conducting contact and pickup and collecting system with a bunched structure or by providing a structure consisting of a plurality ofN thin constituent element combined into a current node.

The experiments conducted by the inventors show that for a statistical sample consisting of a certain plurality (for example, Y >> 1) of thin pickup current-conducting elements of less than 50 $\mu$m in thickness (experiments have been performed to negligibly small sizes) and less than 5000 $\mu$m in length, the electrical resistance of at least one element in the sample will be equal or close to zero. And now, if a statistical sample of N >> 1 p-n-junctions with the adjacent thin portions, i.e. current collectors is combined into a parallel circuit or bunch by means of one or more buses, the resistance in such current node will have a value less than the least value according to the shunt law, i.e. will be equal or close to zero. In practice, zero value in a parallel circuit with a current node was registered in the experiments with Y > 1 number of current-conducting portions for small enough sizes or discrete or line p-n-junctions with their respective collecting regions. No effect of an abrupt electrical resistance drop was provided and observed in the prior art current pickup buses with relatively large linear dimensions using a continuous first conductivity type layer despite their comb structure, i.e. the presence therein of a parallel circuit with a current node and a certain Y > I number of elements, i.e. comb teeth.

In order to create a current node and an abrupt resistance drop, small-sized and discrete (point) or strip (line with small lateral dimension) or grid or line-grid p-n-junctions with the collecting regions and current-conducting portions adjacent thereto are provided. At the same time, N number of strips has be more than one, i.e. N > 1 (for a better resistance reduction effect, preferably N >> 1 and small-sized current collectors are provided), extended (long-length) strips of less than 50 $\mu$m in width and thickness are combined into a current node by means of a transverse current-conducting strip. Such system may be formed by photolithographic printing at a time, i.e. a comb or a cross for implementing a current node is formed at once. In a contact collecting system with the strip-grid and grid configurations which are variations of the strip configuration, a current node is also implemented. The cell sizes in the grid structures should be also minimized and commensurable with the diffusion length of the non-equilibrium MCC, i.e. F << 2f. Moreover, strip buses may be combined into multilayer structures with a dielectric spacer between the main layers together with a single current node whereby the number of constituent elements in the bunch (or stack) is further increased.

In Figs. 2 and 3 an example of discrete collecting regions 2 with comb-strip (line) and cross-shaped strip (line) buses was shown, wherein some of the n-regions extend beyond the metallization 5a and do not create large shading zones, especially for the medium-wave and long-wave radiation. At the same time, the distance between the collecting regions 2 and portions 2a of the first electrode 2 is of principal and fundamental nature. In the instant case, this distance amounts to a value less than the doubled diffusion length F < 2f. In the structures of Figs. 2 and 3, the current node is created by means of the transverse metallization 5a routing.

Fig. 4 shows another configuration of the current-collecting and pickup system. As shown, the strip portions of the first electrode are provided on the first side 1a ofthe substrate 1 deriving from the two connection buses 5a arranged along the opposite edges of said substrate 1 to face the buses arranged on the other edge of the substrate 1a so that the neighboring electrode portions spaced at a distance satisfying inequality (1) derive from different buses (arranged at different substrate 1 edges) according to the "tooth-into-tooth" pattern, i.e. one inside the other. It allows one of the buses on the first side to be electrically connected to the pickup bus on the converter second side. In any case, the distances between buses should be commensurable with the MCC diffusion length, i.e. should satisfy the basic inequality for PEC: F < 2f. The current node in such line configuration is also created by means of the transverse metallization routing shown at 5a.

Figs. 5, 6-12 show other configurations of the strip-line current-collecting pickup buses with transverse elements for combining the current collectors and junctions into a current node.

Fig. 5 shows an example of the grid current-collecting elements with strip current-collecting portions of the first electrode 5a. Needle-shaped buses of a variable longitudinal section are provided in this embodiment in order to reduce the shading, and the distances F between the needle buses are less than 2 f, i.e. F < 2f. The size of F grid cells in this configuration is F << 2f.

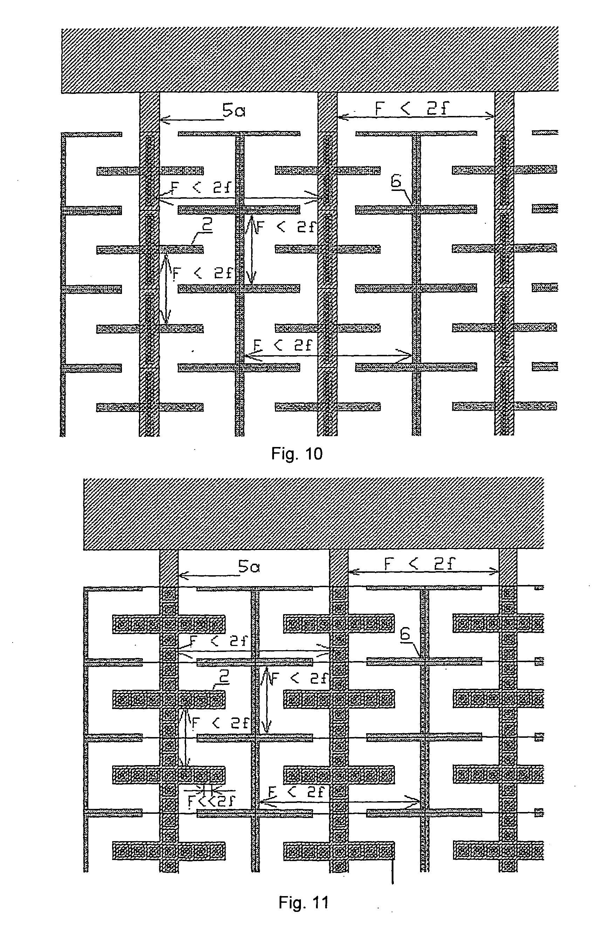

In the embodiments of Figs. 11-12, configurations of the discrete collecting elements 2 are shown, too. The distances F between discrete elements 2 are provided to be less than the diffusion length, i.e. F << 2f.

The embodiment of Fig. 6 is an alternative embodiment wherein the line (strip) current-collecting portions 2 with branches (whisker-like) spaced apart at F << 2f are combined with the needle buses of a variable longitudinal section for reducing the shading and spaced apart at F < 2f.

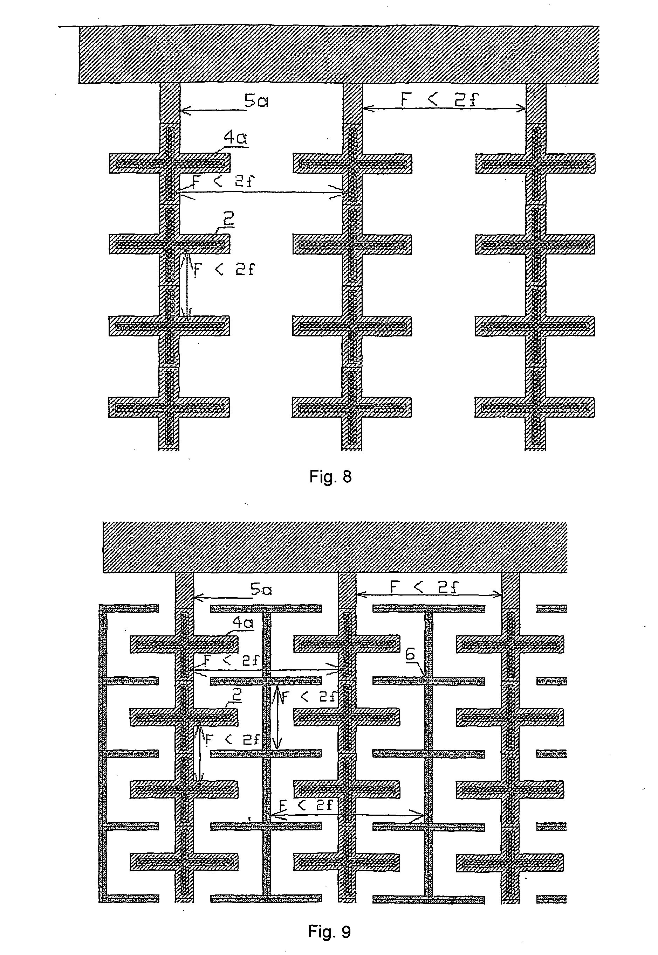

In the embodiments of Figs. 8, 9-10, line and cross-shaped collecting elements are shown; in the embodiments of Figs. 2, 3, 4-6, 10, the collecting regions are partially exposed; in the embodiments of Figs. 8-9, I 1-12, the p-n-junction with the collecting regions are completely shaded.

Shading zones are formed under the n$^+$ regions 2 and the first electrode 5a to a small extent because due to an insignificant spread of shading EMW marginal diffraction occurs, and on the other hand, small shading zones lead to an increase in the concentration gradient and its orientation towards the collecting regions 2 to activate charge separation, i.e. current diffusion component. It turned out (see the disclosure below) that shading of up to 20% and more does not reduce the efficiency of the inventive PEC. At the same time, in all inventive configurations, any of the two converter sides act as the EMR recipient, whether the first side or the second side or both sides at once.

The essence of the invention and the achievement of its technical effect will be further explained by way of other specific examples and embodiments of the double-sided PEC with the above described current-collecting contact system.

Example 2. Double-sided bunched converter with line collecting regions.

This converter when seen in section is similar to the previous one (see Fig, 1a). A first side of this PEC a detail of which is illustrated in Fig. 6 is similar to the first embodiment shown in Fig.1 only that instead of discrete collecting n$^+$ regions it comprises long-length (line) collecting n$^+$ regions 2. On the first side 1a of the second p-conductivity type semiconductor substrate 1 of this PEC, N > 1 first conductivity type line collecting n$^+$ regions 2 are provided, which are isolated from each other by the dielectric layer 4 and together with the substrate form the p-n-junctions 2a, so called conversion zones wherein charge separation takes places followed by generation of the contact voltage drop. The line collecting regions 2 in general comprise a bunched system of N line or strip elements. Each line collecting region 2 may in turn consist of a bunch of thinner collecting elements (the bunch-inside-bunch principle should be observed). Everything depends on whether or not it is possible considering the lithographic printing level and resolution. If allowed by the lithographic printing resolution, the bunched system should be further differentiated so that each line element consists of smaller bunched elements.

The first collecting conducting electrode 5a is connected to the first conductivity type collecting regions and adjacent thereto. The first current-collecting conducting electrode 5a combines the first conductivity type collecting regions 2 into a bunched parallel electric circuit, i.e. a single current node. The conducting buses of the electrode 5a or 5b are isolated from the substrate by the dielectric layer 4.

On the second side, a continuous doped deflecting p$^+$ region 3 is formed adjacent to which the second current collecting conducting electrode 5b is provided. The second side is structurally no different from the previous embodiment and may be implemented in any configuration of the buses shown in Figs. 2-12. As in the first embodiment, in order to reduce the internal resistance a comb or grid with a single current node is produced.

Example 3. Double-sided bunched converter with traditional collecting n$^+$ region and line-grid collecting buses.

The converter according to this embodiment has a simple design (see Figs. 13a and 13). On the first substrate side, a single (N = 1) continuous first conductivity type current-collecting region 2 is provided with one p-n-junction and V > 1 number of the first electrode current-collecting portions in the form of narrow line strips electrically connected to said first conductivity type region, which are combined into a current node and spaced apart from each other at a distance satisfying basic inequality (1): F < 2f, i.e. at intervals commensurable with the length of the MCC diffusion range. In order to reduce the MCC bulk recombination in such converter, the substrate thickness may be reduced to F < f. These SC ensure good current collection both within the long-wave and short-wave regions of the EMR spectrum. The buses on the PEC first and second sides may provided with strip or line ("tooth-into-tooth") configuration as shown in Figs. 4, 6, 7; grid configuration as shown in Fig. 5; cross-shaped configuration as shown in Fig. 8.

Example 4. Double-sided bunched converter with discrete deflecting elements and strip-line and grid collecting buses.

In contrast to the previous embodiments, the PEC according to this embodiment is provided with discrete (or alternatively line) first conductivity type collecting regions 2 on the first substrate side and M discrete highly-doped deflecting elements 3 on the second substrate side 1b (see Fig. 14). Said highly-doped (lightly-doped) deflecting regions 3 are provided on the second side in the same manner as it is shown in Figs. 2-3 for the collecting regions 2. Moreover, the highly-doped discrete p$^+$ regions 3 are arranged directly under the discrete n$^+$ regions 2. Much of the efficiency of such converter depends on the exact positioning of the elements 3 under the elements 2. Furthermore, the highly-doped discrete regions 3 are provided under the strip portions 5b of the second electrode while the regions 3 themselves are isolated from each other by the dielectric 4. At the same time, M > 1 highly-doped regions 3 are combined into a current node my means of the current-collecting portions and bused 5b combining the same into the second electrode. In general, the contact system of the first and second sides may be configured into a grid structure as shown in Fig. 5 or a strip (line) structure as shown in Figs. 2-4, 6-12. Besides, the collecting regions on the first side may be exposed or partially shaded by the appropriate bus configuration. As in other cases, the distance between the collecting elements and pickup buses on the first and second sides satisfies the basic inequality for PEC and amounts to less than the doubled MCC diffusion length, i.e. F < 2f.

Example 5. Double-sided bunched converter with quantum traps.

Converters according of this design are shown in Figs. 15a, 15.1a, 15.1, 16, 17a, 17. Alternatively, quantum traps of various designs and configurations may be provided on different PEC sides. Unlikely the designs illustrated in Examples 1-4, the PEC according to these embodiments can more efficiently convert a wide range of the optically visible and invisible EMR, especially the UV and upper regions of the EMR spectrum.

According to the proposed embodiments, the range of convertible frequencies is expanded from the optically visible radiation towards the high-frequency UV radiation and upper as well as the low-frequency IR radiation and lower, and the MCC surface and bulk recombination MCC is reduced by providing deep quantum traps 7 arranged on the lateral surface throughout the depth between the current-collecting portions of the first (and/or second) electrode in order to allow for the capture and absorption of photons over the SC surface and within its bulk. In the discussed example like in other examples, it is a matter of principle for achieving the claimed technical effect that the relation is observed between the dimensions of the collecting regions and the distances between the same considering the MCC lifetime and its diffusion range.

The quantum traps shown in Figs. 15a, 15 comprise pyramidal (with truncated apex) discrete depressions 7 arranged top end down. Alternatively, depressions with any other geometry are possible. For example, as shown in Fig. 16-17, the pyramidal traps of Fig. 15.1a and Fig. 15 may be alternatively configured as vertical grooves (trough) whose section is formed as the reversed truncated pyramid 7 (or aqueduct trough), and as seen in these figures the configurations of various quantum traps may be combined. For example, an "aqueduct"-type configuration may be provided on the first side, and a grooved delta-shaped configuration or a pyramidal discrete configuration, etc. may be provided on the second side. The distances between the traps with the current-collecting portions 5a (or 5b) are commensurable with the MCC diffusion length.

The quantum traps 7 are provided between the current-collecting line strip (comb) portions of the respective electrode along the thin strips or teeth of such comb. The current-conducting strip 5a (or the comb tooth 5b) extends along the quantum trap on the converter first side (or second side) so as to partially cover the converter first side along the trap position allowing thereby for collection of charges from the surface or within the bulk of the converter and eliminating the surface and bulk recombination. The distance between the quantum traps is commensurable with the MCC diffusion length, i.e. the length satisfying the basic inequality for PEC F < 2f. Due to such configurations, an increase is provided in the depth and region of penetration of the high-energy short-wave EMR spectrum region into the semiconductor substrate. At the same time, the quantum trap is provided to have a sufficiently large depth in order to allow for efficient capture of the short-wave quanta throughout the converter bulk.

Example 6. Double-sided bunched converter with deflecting clements and quantum traps.

Figs. 18a, 18, 19a, 19b, 19c show the converters with a deflecting system. In contrast to the previous examples, additional internal deflecting electric fields are built in the quantum traps by means of elements 6 in this PEC to allow for carrying out an efficient control of the MCC current collection and recombination process both at the surface of and within the PEC bulk. To this end, discrete (separate) longitudinal, etc. deflecting first conductivity type n$^+$ regions 6 or second conductivity type p$^+$ regions 6a are provided on the second side between the regions 2 and/or electrode portions by doping the substrate I surface. The deflecting built-in fields generated owing to the deflecting regions 6, 6a will readily and efficiently eliminate the MCC recombination MC making it possible to control the efficiency of the PEC operation. The deflecting elements 6 may be designed to be extended and closed around the collecting elements or regions 2 (see Figs. 9-12) and also to be discrete and positioned around the current-collecting elements 2 (see Fig. 12).

Various configurations of the quantum traps arc used combined in the converter with the deflecting elements as in the converter of Example 5.

Figs. 18a and 18 show a detail of the double-sided converter with deflecting n$^+$ elements 6 and "aqueduct"-like quantum traps (longitudinal in plan view and in the form of a truncated pyramid or a trapezium in cross-section, on the first side) and grooved delta-shaped quantum traps (on the second side). The continuous deflecting p$^+$ layer 3 is provided.

Fig. 19a shows a detail of the double-sided converter with deflecting n$^+$ elements 6, p$^+$ elements 6a and "aqueduct"-like quantum traps (on the first side) and "pyramid"-like quantum traps (on the second side). Discontinuous and deep deflecting p$^+$ elements 3 and 6a are provided.

Fig. 19b shows a detail of the double-sided converter with deflecting n$^+$ elements 6, p$^+$ elements 6a and "aqueduct"-like quantum traps (on the first side) and "pyramid"-like quantum traps (on the second side). Discontinuous deflecting p$^+$ elements 3 and 6a are provided.

Fig. 19c shows a detail of the double-sided converter with deflecting n$^+$ elements 6, p$^+$ elements 6a and "aqueduct"-like quantum traps (on the first side) and "pyramid"-like quantum traps (on the second side). Discontinuous deflecting p$^+$ elements 3 and 6a are provided. Regions 2 and 3 are provided oppositely to each other.

The distances between the current-collecting and pickup buses as well as the distances between the deflecting elements also satisfy basic inequality (I) for the inventive PEC: F < 2f.

Example 7. Double-sided bunched converter with field-effect control electrode.

The PEC according to this Example (see Fig. 20) differs fundamentally from the other Examples in that, while the previous embodiments were in fact based on the diffusion current mechanisms, in the instant Example the latter are supplemented with the drift current effects so that the diffusion-drift current will be produced as the converter total current. At the same time, the same conditions apply for inequality between the MCC location and the current collectors, i.e. the distances between the collecting regions 2 and/or electrode portions as before amount to F < 2f. Between the conducting portions 5a (alternatively, between the second electrode 5b portions), an expanded electrode of polysilicon Si* layer 10 is provided (just as it is done in MOS capacitors or transistors to which a bias potential is applied, for example, from p-n-junctions or other EMF source). By applying various bias potential to the field-effect electrode 10 via the contact 5d one may adjust the MCC recombination and ultimately increase the photocurrent value and the energy conversion efficiency of the PEC.

An embodiment of the combined PEC configuration is illustrated in Fig. 20 showing a detail of the double-sided converter with the expanded field-effect control electrode 10, discrete deflecting elements 3, 6, 6a and quantum traps 7. The metal contact 5d is electrically connected to the field-effect electrode 10 based, for example, on polysilicon Si*. Various configurations and arrangements of the field-effect control electrodes are conceivable. Field-effect electrodes may be arranged either on the first side or the second side or simultaneously on both PEC sides. At the same time, various configurations of the deflecting elements 3, 6, 6a are conceivable: extended, continuous, discrete, uninterrupted and discontinuous.

Field-effect control electrodes and optimum distances between the current-collecting and pickup elements (in accordance with inequalities (1) and (3)) allow the current collection to be performed in the PEC with least possible losses and high efficiency.

Example 8. Double-sided bunched multijunction converter with multistage voltage multiplication.

In contrast to the previous Example, rather than using built-in field-effect control electrodes with deflecting fields, the PEC according to this configuration are provided with built-in discrete multistage open-circuit voltage multipliers which depending on the number of p-n-junctions increase the PEC potential. The losses leading to a reduced converter efficiency are practically eliminated in such converter.

Fig. 21 shows a detail of the double-sided bunched converter with the first conductivity type discrete collecting regions 2 (on the first side) and multistage open-circuit voltage multiplier (on the second side). A single junction in such configuration comprises a single voltage amplification (multiplication) stage. If the number of stages (or p-n-junctions) in an elementary cell of the PEC is $N_\kappa$, the total voltage will be multiplied by $N_\kappa$ times. As shown in Fig. 21, the number of multiplication stages amounts to $N_\kappa = 2$. More than 1 or more than 10 or more than 100 or more than 1,000, 10,000 multipliers may be provided in the PEC elementary cell. Alternatively, $N_\kappa = 1$.

In the voltage multiplier shown in Fig. 21 (PEC second side), the second conductivity type region 3 is created in the first conductivity type 8 region forming the p-n-junction 8a with the substrate 1, short-circuited by the metal bridge 9. The p-n-junction 8b formed by the regions 3 and 8 forms a diode for increasing the open-circuit voltage of the converter. However, PEC may alternatively be provided without the bridge 9. The distances between the current collectors and pickups in this PEC modification also satisfy basic inequality for PEC (I).

Figs. 22a and 22 show another particular embodiment of the PEC with the built-in multistage voltage multiplier. These figures, in particular show a detail of the double-sided discrete converter with the elementary multistage open-circuit voltage multiplier (on the first side, Fig. 22a) with the continuous deflecting layer 3 (on the second side, Fig.22). As shown in Fig. 22a and 22, said detail comprises a PEC subcell with one elementary multistage voltage multiplier. The number of such subcells with the elementary multistage voltage multiplier in the entire elementary cell of the PEC amounts to $Q > 1$ (alternatively, there may be cases wherein $Q = 1$ or $Q \gg 1$).

An elementary stage of the multiplier comprises a series of alternating opposite conductivity type layers; for example, in the second p-conductivity type substrate 1 the first conductivity type doped layer 14 is formed, wherein in turn the p-layer 13 is formed and in the latter the n-layer 12 is formed, wherein the layer 11 is formed, etc. In addition $n^+$ and $p^+$ layers alternate. By alternation of these layers, a series of $N_\kappa$ number of p-n-junctions 2a, 11a, 12a, 13a, 14a, etc is formed. As shown in Fig. 22a and 22, the junctions 11a, 13a may be short-circuited by the metallization 15b, 15c via the contact windows 4b, 4c. Alternatively, they are not short-circuited.

The collecting region 2 via the contact window 4a in the dielectric 4 is connected to the current-collecting elements of the first electrode 5a, by means of which the multistage elements are combined into a current node. The PEC subcells with the elementary voltage multiplier may be combined into a PEC cell according to various patterns, for example, "head-to-head", "end-to-end" or "head-to-end". In addition, the same fundamental principle for building PEC with the voltage multiplier applies: the current collectors and pickups are arranged according to basic inequality (1) for the inventive PEC.

Example 9. Double-sided bunched converter with optimum-thickness semiconductor substrate.

The converter according to this embodiment, unlike all previous Examples, is **characterized in that** for an efficient current collection the semiconductor substrate thickness is limited. As a matter of fact, the PEC according to all embodiments shown in Figs. 1, 1a, 13-22 have a thickness relying on the basic inequality for PEC. Therefore, for an efficient collection and elimination of the bulk recombination, the semiconductor plate should have a thickness (to be exact, a distance from the collecting region 2 to the deflecting regions 3) of less than $F < f$. This is done in order that the charge generated under the action of the EMR quantum does not recombine with the bulk and would be able to reach directly the nearest current collector arranged on the first or second substrate side (see Fig. 20). By adjusting the thickness of the semiconductor substrate plate according to the basic inequality for PEC the EMR range can be expanded towards the visible and invisible frequencies.

EXPERIMENTAL EVIDENCE OF IMPLEMENTATION OF THE TECHNICAL EFFECT

Classical continuous single-junction PEC known in the art (see Fig. 21) comprise current collection buses 5a of up to 200-300 $\mu$m in width spaced apart from each other at an interval of $F > f$ (i.e. 800-3000 $\mu$m). At the same time, the MCC concentration gradient along the X axis is practically equalized such that the diffusion current component is dependent on the change in concentration along the Y axis and on the region 2 field (i.e. on the transverse diffusion current component) and is directed along the Y axis (Fig. 23).

In the Examples 1-9 illustrated in Figs. 1-22d, a contact and current collection system is used in the form of narrow interrelated distributed or point contacts 4a in the dielectric 4 and ofN strip, line, narrow, whisker or grid current-collecting metallized strips 5a or 5b combined by a common (backbone) bus into a single current node and arranged according to the basic inequality for PEC at F < 2f from each other, where f is the MCC diffusion length.

No, or considering a small marginal diffraction, insignificant MCC generation takes place under the buses which form the shading regions. Accordingly, a strong longitudinal charge concentration gradient is artificially created at the interface of shading the converter I bulk by the nontransparent (metal) electrode 5a or 5b so that a longitudinal diffusion current component is formed.

Therefore, a longitudinal component along the X axis is added in the inventive converters to the transverse diffusion current component along the Y axis. As a result, the total diffusion current is summed up, with the X-component being far in excess of the Y- component whereby a substantial increase in the power and efficiency of the PEC according to the proposed embodiment is achieved. In addition, the total effect and the value of the longitudinal diffusion current component is dependent on the periodicity of the inhomogeneities creating the MCC concentration gradient, i.e. on the number of regions 2 and strip portions 5a, 5b shading the substrate and thereby changing the concentration gradient.

As it turned out, the region shading system not only creates a longitudinal diffusion current component but also positively influences the converter internal resistance practically without affecting the output current value dependent on an increase in the total shading region.

In evidence of implementation of the claimed technical effects, specimens of the bunched converters with transverse and longitudinal diffusive current components have been produced. Specimens of the inventive PEC with continuous p-n-junetion and narrow current-collecting electrode Portions of far less than 50 $\mu$m in width and a distance between these portions commensurable with the MCC diffusion length have been produced as well as standard control PEC with continuous p-n-junction and wide current-collecting buses spaced at 2000-3000 $\mu$m.

The measurement data of these PEC within the spectrum of a conventional incandescent lamp are presented Fig. 24 showing the relations of the short-circuit current density ($I_{\kappa3}$) for control (curve 16) and experimental (curves 17-19) specimens: 16 - an embodiment of the standard control specimen with continuous p-n-junction, current collection buses of 200 $\mu$m in width, the distance between the current-collecting buses of 2000 $\mu$m, and the level of shading by metallization of 8.4%; 17 - a specimen with continuous current collection layer according to the embodiment of Fig. 7 or 23, current-collecting buses of 18 $\mu$m in width, the distance between the current-collecting buses of less than 200 $\mu$m, and the level of shading by metallization of 8.2%; 18 - a specimen with cross-shaped current-collecting regions 2 completely covered by metallization as shown in Fig. 4, of 18 $\mu$m in width, the distance between the current-collecting buses of 200 $\mu$m, and the level of shading by metallization of up to 25%; 19 - the embodiment of Fig. 10 with partially exposed discrete cross-shaped elements but with no deflecting elements 6 and with the level of shading by metallization of 8,2%.

The area ratio of the collecting regions 2 in the embodiments shown by curves 8-9 and those shown by curves 10-11 is 10:1, i.e. the area of collecting n+ region in the embodiments shown by curves 10 and 11 is by an order of magnitude less than that in the embodiments shown by curves 8 and 9.

Curve 16 in Fig. 24 demonstrates the short-circuit current saturation at 60 mA for the PEC with continuous junctions due to a high internal resistance of the "dead" layer 2: minority carriers generated within the converter bulk lower than the "dead" layer move towards this layer to be collected by the same and to move further along this layer towards the buses 5a.

The density $j_v$ of the diffusion current transverse component given the concentration gradient dn/dy is:

$$j_Y = qD(dn/dy) \qquad\qquad (4),$$

where q is an electron charge, D is a diffusion factor.

In the presence of the longitudinal component of the concentration gradient dn/dx which is dependent on the shading zones, the longitudinal current component is formed:

$$j_X = qD\,(dn/dx) \qquad\qquad (5),$$

and due to an abrupt concentration gradient, i.e. when (dn/dx) > (dn/dy), the longitudinal current component density exceeds the transverse current component density: $j_x > j_v$.

The total current density is:

$$j = j_X + j_Y \qquad\qquad (6).$$

This is proved by the short-circuit current-light intensity curve (curve 16) seen far below curves 17-19 along the current axis. It is also due to the fact that a considerable share of the generated MCC would recombine having not reached tile current-collecting layer 2.

Given the distances between electrodes commensurable with the MCC diffusion lengths, the carriers of the respective transverse diffusive current component will freely reach the current-collecting electrodes so that curves 17-19 are seen significantly higher along the current axis.

Curves 17, 19 exemplify the longitudinal component effect of the diffusion current, which in contrast to the transverse component of the short-circuit diffusion current is not proportionate to the p-n-junction area. As shown in Fig. 24, curves 17, 19 defining the longitudinal diffusion current effect are seen far higher along the current axis.

Therefore, the experimental findings demonstrate that in order to achieve a maximum current collection effect, it is necessary to optimize the positioning of the current-collecting regions in accordance with the basic inequality for PEC and to create a system of artificial surface-bulk microinhomogeneities (SASBM) comprising, in the general case, not only the alternation of n$^+$ and p$^+$ regions but also a system of shaded portions increasing the MCC concentration gradient.

In the general case, the analysis of the SC made according to the invention testifies that under the influence of a radiation quantum the MCC generation occurs anywhere throughout the substrate, whether in the n-layer or the p-layer. Therefore, a charge concentration gradient should be artificially created, charges should be separated by means of a field of N (built-in) p-n-junctions and efficiently combined by means of a line-grid structure of current-collecting regions in accordance with the basic inequality for MCC diffusion lengths to enable formation of a current node with p-n-junction resistance.

The current voltage response measured in AMO conditions, 1353 W/m at 25°C also proves the inventive technical effect. Fig. 25 shows the CVR for the control SC with the distance of 2000 $\mu$m between the current-collecting buses (curve 22) and for the embodiment with the distance according to the basic inequality for PEC F < 2f (curve 23) and F = 2f (curve 22). It can be seen from Fig. 25 that the inventive SC CVR is substantially different: curves 22 and 23 are shown far higher along the current axis. The maximum efficiency estimate based on these curves shows that it is in excess of 28-30% for the inventive SC, which gives evidence of a qualitative leap of the solar energy conversion.

Fig. 26 show the current density curves within the TR range (a 150 W incandescent lamp with an infrared source operating within the range of from 30-900 to 200,000 nm was used for the measurements) for the control SC (curve 24) and for the inventive discrete SC with the distances between the current-collecting regions in accordance with the basic inequality for PEC (curves 24 and 25). The illumination intensity was changed by bringing the source closer to the converter so that the specimen temperature increased from 298 K to 473 K. As can be seen from Fig. 26, the standard control SC passes through the saturation point and degrades under exposure to the intensive IR radiation and temperature whereas an increase in current was observed for the experimental inventive PEC under the same conditions. No current characteristic saturation was obtained to the extent of the measured illumination intensities. In general, a value of photocurrent increases in proportion to an increase in the illumination intensity. This demonstrates that photocurrent is not proportionate to the illuminated p-n-junction area in case of the inventive SC configuration as it the case was in the prior art. Therefore, the PEC proposed by the inventors are in principal distinguished from the prior art.

In general, the inventive PEC measurements carried out show that the claimed converters operate within a wide EMR range from the visible and invisible region to the UV, roentgen and higher spectra as well as within the near-IR and lower spectra. The inventive PEC including but not limited to the configurations with deflecting and drift control fields make it possible to control and adjust the energy conversion amount and efficiency in the inventive SC. In Table 1, SC characteristics (open-circuit voltage and short-circuit current) are given as an example of a wide EMR range. It can be seen from the available data and table that while current and EMF is generated by the control SC only within the visible EMR spectrum region, it is generated by the inventive SC both within the visible and invisible regions ranging from the IR to the UV and roentgen radiation, with the value of the short-circuit currents and open-circuit voltage of the inventive PEC being by an order of magnitude in excess of that of the standard control specimens.

The spectral response of the standard SC is limited both within the short-wave (UV and higher) and the long-wave TR regions not so much by the properties of silicon but by the converter design features, being practically equal to zero beyond the range of 400-1200 nm (Fig. 27, curve 26). Curve 26 of Fig. 27 demonstrates an increment in the current density of the standard industrial SC, i.e. the contribution of each of the solar spectrum waves to the short-circuit current density.

Curve 27 (Fig. 27) illustrates the increments in the short-circuit current density of the inventive bunched converter measured at various EMR frequencies. The spectral response of the bunched diffusion SC made subject to the basic inequality for PEC is substantially wider (Fig. 27, curve 27). At the same time, three absorption maximums are formed along the current density increment-EMR length curve, one - within the cold region at 500 nm, another one - within the visible region, and the third one within the IR region at 1700 $\mu$m. Therefore, the PEC according to the invention is superior to the prior art not only in terms of the current-voltage response but also of the spectral response allowing practically the entire spectrum of the incident electromagnetic radiation reaching the Earth to be converted. Moreover, the PEC according to the invention is insensitive to large temperature and insolation drops.

Fig. 28 and Fig. 29 show the relations of the short-circuit currents and open-circuit voltage for the control and inventive PEC under simultaneous exposure to IR radiation and temperature. As can be seen, the control PEC (curve 28) is practically inoperable under simultaneous exposure to IR radiation and temperature. At the same time, as can be seen from Figs. 28 and 29, the efficiency of the inventive PEC according to the invention in operation conditions, for example, at T = 80°C (being the highest temperature a SC is heated to on earth when exposed to a maximum illumination in actual practice) is nearly two times superior to the efficiency of the control PEC, i.e. the prior art. Curves 29 and 30 illustrate a PEC without deflecting $p^+$ elements, curve 31 illustrates a discrete converter with deflecting regions and a distance of < 2f between the current-collecting buses (see Fig. 10). As can be seen, the operational performance of the proposed inventive PEC is not only practically affected under exposure to IR radiation and temperature but also an increase in the short-circuit current is observed up to 100-120°C. Therefore, the technical effect is in general demonstrated by means of direct implementation of the claimed invention.

It should be noted that the claimed technical effect is also demonstrated by the inventive PEC made according to other embodiments. The most impressive results have been achieved using the converters with the built-in multistage open-circuit voltage multipliers (see Fig. 21-22d).

In conclusion, it should be noted that the above examples have been provided only for a better understanding of the essence of the invention as well as its advantages and by no means encompass all possible particular embodiments of the same.

It will be obvious to a person skilled in the art that other particular embodiments of the invention are also possible, in particular characterized, for example, by materials used for the substrate, contact system and current-conducting paths, configurations of converters, etc., distinguished from the ones explicitly disclosed herein but well known and used in the art for similar purposes as well as characterized by the number of p-n-junctions not explicitly disclosed herein but unequivocally following from the essence of the invention. Moreover, approaches used herein may apply to producing other semiconductor devices with a diode structure - photodiodes, diodes, light-emitting diodes, transistors, phototransistors, thyristors, semiconductor lasers, photoresistors, etc. Other particular embodiments of the invention are also conceivable also within the scope of the legal protection sought for and defined by the accompanying claims.

INDUSTRIAL APPLICABILITY

Electromagnetic radiation (EMR) converters are applicable for producing wideband high-performance photoelectric converters (PEC).

**Claims**

1. An electromagnetic radiation converter comprising at least one collecting region of a first conductivity type and at least one collecting region of a second conductivity type as well as first and second current-collecting conducting electrodes connected to said regions, **characterized in that** on a first, second conductivity type substrate side sensitive to the incident electromagnetic radiation, N > 1 first conductivity type regions are arranged, each region being spaced at a distance of F < 2f from other regions of the same conductivity type, where f is a value commensurable with or equal to the diffusion length of non-equilibrium minority charge carriers.

2. The converter according to claim 1, **characterized in that** said first current-collecting electrode is electrically connected to each of said N first conductivity type regions.

3. The converter according to claim 2, **characterized in that** said first current-collecting electrode comprises N portions each of which is adjacent to one of said N first conductivity regions, with said N portions of the first electrode being combined by means of at least one current bus.

4. The converter according to claim 3, **characterized in that** said first electrode portions comprise strips.

5. The converter according to claim 4, **characterized in that** the width of each strip portion of the first electrode is not in excess of 50 $\mu$m.

**6.** The converter according to claim 4, **characterized in that** said strip portions are spaced apart from each other at a distance of less than 2f.

**7.** The converter according to any of claims 4-6, **characterized in that** on the first substrate side between said portions of the first electrode, discrete quantum trapping depressions are provided of a pyramidal form in section, arranged on the substrate top end down at a distance from each other of less than 2f.

**8.** The converter according to any of claims 4-6, **characterize in that** on the first substrate side between said portions of the first electrode, discrete quantum trapping depressions are provided of a pyramidal form in section with truncated apex, arranged on the substrate top end down at a distance from each other of less than 2f.

**9.** The converter according to claim 7, **characterized in that** said quantum trapping depressions comprise cannelures in plan view arranged on the converter first side.

**10.** The converter according to claim 8, **characterized in that** said quantum trapping depressions comprise cannelures in plan view arranged on the converter first side.

**11.** The converter according to any of claims 1-6, **characterized in that** on the first substrate side, a dielectric layer is provided transparent to the electromagnetic radiation, comprising recesses (apertures) at least within the regions of the electric contacts of the first electrode with the first conductivity type regions.

**12.** The converter according to any of claims 9, 10, **characterized in that** on the first substrate side, a dielectric layer is provided transparent to the electromagnetic radiation, comprising recesses (apertures) at least within the electric contact regions of the first electrode with the first conductivity type regions.

**13.** The converter according to claim 12, **characterized in that** second conductivity type deflecting regions are provided under the dielectric layer at the bottom of each of said cannelures,

**14.** The converter according to claim 13, **characterized in that** said second conductivity type deflecting regions comprise discrete or strip regions.

**15.** The converter according to any of claims 1-6, 9, 10, 13, 14, **characterized in that** the second current-collecting electrode is arranged on the second substrate side on top of the dielectric layer transparent to the electromagnetic radiation and comprising recesses (apertures) at least within the regions of the second electrode electric contacts with at least second conductivity type region provided on the second substrate side.

**16.** The converter according to claim 12, **characterized in that** the second current-collecting electrode is arranged on the second substrate side on top of the dielectric layer transparent to the electromagnetic radiation and comprising recesses (apertures) at least within the regions of the second electrode electric contacts with at least second conductivity type region provided on the second substrate side.

**17.** The converter according to claim 15, **characterized in that** said the second electrode comprises M > 1 portions each of which is electrically connected to at least one second conductivity type region on the second substrate side, with said portions being combined by means at least one current-conducting bus.

**18.** The converter according to claim 16, **characterized in that** said M portions of the second electrode comprise strip portions, with a distance between each two strips comprising a value less than 2f.

**19.** The converter according to any of claims 17, 18, **characterized in that** on the second side thereof between said portions of the first electrode, discrete quantum trapping depressions are provided of a pyramidal or tapered pyramidal form in section, arranged on the substrate top end inward the substrate thickness, with their base on the second side thereof, at a distance from each other of less than 2f.

**20.** The converter according to any of claims 17, 18, **characterized in that** on the second side thereof, at least two second conductivity type doped regions are provided to each of which at least one of M portions of the second electrode is electrically connected.

**21.** The converter according to claim 19, **characterized in that** on the second side thereof, at least two second conductivity type doped regions are provided to each of which at least one of M portions of the second electrode is electrically connected.

22. The converter according to claim 21, **characterized in that** the number of said second conductivity type doped regions on the second substrate side is M, with one portion of the second electrode being connected to each of said regions.

23. The converter according to claims 21 or 22, **characterized in that** at the bottom of each of said depressions on the second side, second conductivity type deflecting regions are provided so that each ofN first conductivity type regions has at least one such deflecting region arranged on the second side opposite thereto across the substrate thickness.

24. The converter according to claim 12, **characterized in that** a field-effect control electrode is arranged above the dielectric layer on the first side of the semiconductor substrate.

25. The converter according to any of claims 1-6, 9, 10, 13, 14, 16-18, 21, 22, 24, **characterized in that** semiconductor substrate has a thickness not exceeding f, where f is a value commensurable with the diffusion length or equal to the diffusion length of the non-equilibrium minority charge carriers.

26. The converter according to any of claims 1-6, 9, 10, 13, 14, 16-18, 21, 22, 24, **characterized in that** built-in multistagediscrete voltage multipliers are provided on the first side thereof.

27. The converter according to any of claims 1-6, 9, 10, 13, 14, 16-18, 21, 22, 24, **characterized in that** on at least one side thereof, a built-in three-stage voltage multiplier is provided, whose first stage comprising a Schottky diode structure converts a short-wave region, a second stage converts a medium-wave region and a third stage converts a long-wave region of the EMR spectrum, with all three stages being combined into a single current node in the converter internal circuit.

28. The converter according to any of claims 1-6, 9, 10, 13, 14, 16-18, 21, 22, 24, **characterized in that** the current-conducting elements and electrodes comprise a diffraction grating, grid or Fresnel lenses.

29. An electromagnetic radiation converter comprising one collecting region of a first conductivity type and at least one collecting region of a second conductivity type as well as first and second current-collecting conducting electrodes connected to said regions, **characterized in that** said first electrode is connected to said first conductivity type region provided on a first, second conductivity type substrate side sensitive to the incident electromagnetic radiation, with said first electrode comprising T > 1 portions and the distance between each two of said portions being less than 2f, where f is a quantity commensurable with or equal to the diffusion length of non-equilibrium minority charge carriers, wherein said portions of the first electrode are combined into a current node in the converter internal circuit by at least one current-conducting bus.

30. The converter according to claim 29, **characterized in that** on the first substrate side, a dielectric layer is provided transparent to the electromagnetic radiation, comprising recesses (apertures) at least within the electric contact regions portions of the first electrode with said first conductivity type collecting region.

31. The converter according to any of claims 29-30, **characterized in that** on the first semiconductor substrate side sensitive to the incident electromagnetic radiation, built-in multistage discrete voltage multipliers are provided combined into a single current node in the converter internal circuit.

32. The converter according to any of claims 29, 30, **characterized in that** on any of the semiconductor substrate sides, a built-in three-stage converter is provided, whose first stage comprising a Schottky diode structure converts a short-wave region, a second stage converts a medium-wave region and a third stage converts a long-wave region of the EMR spectrum, with all three stages being combined into a single current node in the converter internal circuit.

33. The converter according to any of claims 29, 30, **characterized in that** the current-conducting elements and electrodes comprise a diffraction grating, grid or Fresnel lenses.

Fig. 1

Fig. 1a

Fig. 2

Fig. 3

**2**

**2a**

**2**

**4a**

**1a**

F < 2f

5a

Fig. 4

**2**

**4a**

F ≤ 2f

5a

F << 2f

F << 2f

Fig. 5

**2** →

**4a**

F < 2f

F << 2f

**5a**

Fig. 6

F < 2f

**3**

**4b**

**5b**

Fig. 7

Fig. 8

Fig. 9

Fig. 10

Fig. 11

Fig. 12

Fig. 13a

Fig. 13

Fig. 14

Fig. 15a

Fig. 15

Fig. 15.1a

Fig. 15.1

Fig. 16

Fig. 17a

Fig. 17

Fig. 18a

Fig. 18

Fig. 19a

Fig. 19b

Fig. 19c

Fig. 20

Fig. 21

Fig. 22a

Fig. 22

Fig. 22b

Fig. 22c

Fig. 22d

Fig. 23

Fig. 24

Fig. 25

Fig. 26

Fig. 27

Fig. 28

Fig. 29

## INTERNATIONAL SEARCH REPORT

| International application No. |
|---|
| PCT/RU 2008/000490 |

**A. CLASSIFICATION OF SUBJECT MATTER**

HO1L 31/04 (2006.01)

According to International Patent Classification (IPC) or to both national classification and IPC

**B. FIELDS SEARCHED**

Minimum documentation searched (classification system followed by classification symbols)

HO1L 31/00, 31/04, 31/042

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | S. Zi. Fizika poluprovodnikovykh priborov. Tom 2, Mir, Moskva, 1984, p. 412-417 | 1-4, 6<br>29 |
| Y | JP 6053531 A (SHARP KK) 25.02.1994, the abstract | 29 |
| A | SU 288163 A (STREBKOV D.S. et al.) 05.02.1971 | 1-33 |
| A | SU 288161 A (LANDSMAN A.P. et al.) 09.03.1971 | 1-33 |

☐ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 27 October 2008 (27.10.2008) | 06 November 2008 (06.11.2008) |

| Name and mailing address of the ISA/<br><br>RU<br><br>Facsimile No. | Authorized officer<br><br><br>Telephone No. |
|---|---|

Form PCT/ISA/210 (second sheet) (July 1998)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3206350 B
- RU 2139601 C1
- DE 10127382 A1
- US 6998288 B1
- RU 2284267 C2

### Non-patent literature cited in the description

- **Alferov Zh.J. ; Andreev V.M. ; Rumyantsev V.D.** Development Trends and Prospects of Solar Power Engineering. *Semiconductor Physics and Technology,* 2004, vol. 38 (8), 937-948
- **Meitin M.** Photovoltaics: Materials. Technologies. *Prospects // Electronics: Science, Technology, Business,* 2000, vol. 6, 40-46
- **Konstantinov P.B. ; Kontsevoy Yu.A. ; Maksimov Yu.A.** Silicon Solar Cells. MIREA Publishers, 2005, 70
- **Reivi K.** Defects and Impurities in Semiconducting Silicon. Mir Publishers, 1984, 470
- **Zaveryuikhin B.N. ; Zaveryuikhina N.N. ; Tursunkulov O.M.** Changes in the Reflection Factor of Radiation from the Semiconductor Surface within the Spectral Range of $\lambda$ = 0.2-20 $\mu$m under the Influence of Ultrasonic Waves. *Letters to the Journal of Applied Physics,* 2002, vol. 28 (18), 1-12
- **Green M.A et al.** 25% Efficient Low-Resistivity Si Concentrator Solar Cells. *IEE Electron Device Letters,* 1986, 583-585
- **Goodrich J. ; Chaple-Sokol. ; Allendore G. ; Frank R.** The etched multiple vertical junction silicon photovoltaic cell. *Solar Cells,* 1982, vol. 6 (1), 87-101
- **Aberie A.G. ; Altermatt P.P. ; Heizer G ; Robinson S.J.** Limiting loss mechanisms in 23% efficient silicon solar cells. *J.Appl. Phys.,* 1995, vol. 77 (7), 3491
- **Untila G.G. ; Kost T.N. ; Zaks M.B. et al.** New Type of High-performance Two-Sided Silicon Solar Cella with External Buses and Wire Grid. *Semiconductor Physics and Technology,* 2005, vol. 39 (11), 1393-1398
- **Alferov Zh.I. ; Andreev V.M. ; Rumyantsev V.D.** Development Trends and Prospects of Solar Power Engineering. *Semiconductor Physics and Technology,* 2004, vol. 38 (8), 937-948
- **Meitin M.** Photovoltaics: Materials, Technologies, Prospects. *Electronics: Science, Technology, Business,* 2000, 40-46
- **Kartashov E.M. ; Tsoi B. ; Shevelev V.V.** The Structural and Statistical Kinetics of Polymer Destruction. Khirnia Publishers, 2002, 736
- **Tsoi B. ; Lavrentiev V.V. ; Kartashov E.M. ; Shevelev V.V.** *Electroinsulating Material,* 26 October 2004, vol. 2, 284, 593